# FASCICULE DE BREVET EUROPEEN

(11) **EP 3 472 668 B1**
(45) Date de publication et mention de la délivrance du brevet: **12.02.2020**
(21) Numéro de dépôt: 17737336.2
(22) Date de dépôt: 21.06.2017
(51) Int. Cl.: G03F 1/00, G03F 1/68, G03F 7/20

(54) **SYSTÈME ET MÉTHODE DE RÉALISATION D'UN MASQUE OPTIQUE POUR TRAITEMENT DE SURFACE, INSTALLATION ET MÉTHODE DE TRAITEMENT DE SURFACE**
SYSTEM UND VERFAHREN ZUR HERSTELLUNG EINER OPTISCHEN MASKE ZUR OBERFLÄCHENBEHANDLUNG SOWIE OBERFLÄCHENBEHANDLUNGSANLAGE UND VERFAHREN
SYSTEM AND METHOD FOR PRODUCING AN OPTICAL MASK FOR SURFACE TREATMENT, AND SURFACE TREATMENT PLANT AND METHOD

(30) Priorité: 21.06.2016 FR 1655751
(43) Date de publication de la demande: 24.04.2019
(73) Titulaire: H.E.F., 42160 Andrézieux-Bouthéon (FR); Université Jean Monnet de Saint-Etienne, 42023 Saint-Etienne Cedex 2 (FR); Centre National de la Recherche Scientifique CNRS, 75794 Paris Cedex 16 (FR)
(72) Inventeur: BICHOTTE, Maxime, 67500 Haguenau (FR); JOURLIN, Yves, 42000 Saint-Etienne (FR); DUBOST, Laurent, 42330 Chamboeuf (FR)
(74) Mandataire: Cabinet Laurent & Charras
(86) Numéro de dépôt international: PCT/FR2017/051648
(87) Numéro de publication internationale: WO 2017/220929

(56) Documents cités:
- EP-A1- 0 759 578
- GB-A- 2 253 925
- ALIREZA BONAKDAR ET AL: "Deep-UV microsphere projection lithography", OPTICS LETTERS, vol. 40, no. 11, 1 juin 2015 (2015-06-01), page 2537, XP055368966, ISSN: 0146-9592, DOI: 10.1364/OL.40.002537
- PIERRE COLSON ET AL: "Nanosphere Lithography: A Powerful Method for the Controlled Manufacturing of Nanomaterials", JOURNAL OF NANOMATERIALS, vol. 2013, 1 janvier 2013 (2013-01-01), pages 1-19, XP055368541, US ISSN: 1687-4110, DOI: 10.1155/2013/948510
- HAUPT M ET AL: "Breath figures: Self-organizing masks for the fabrication of photonic crystals and dichroic filters", JOURNAL OF APPLIED PHYSICS, AMERICAN INSTITUTE OF PHYSICS, US, vol. 96, no. 6, 1 janvier 2004 (2004-01-01), pages 3065-3069, XP012068784, ISSN: 0021-8979, DOI: 10.1063/1.1778219
- VARANASI KRIPA ET AL: "Spatial control in the heterogeneous nucleation of water", APPLIED PHYSICS LETTERS, A I P PUBLISHING LLC, US, vol. 95, no. 9, 31 août 2009 (2009-08-31), pages 94101-94101, XP012122946, ISSN: 0003-6951, DOI: 10.1063/1.3200951
- BISETTO A ET AL: "Dropwise condensation on superhydrophobic nanostructured surfaces: literature review and experimental analysis", JOURNAL OF PHYSICS: CONFERENCE SERIES, INSTITUTE OF PHYSICS PUBLISHING, BRISTOL, GB, vol. 501, no. 1, 10 avril 2014 (2014-04-10), page 12028, XP020261335, ISSN: 1742-6596, DOI: 10.1088/1742-6596/501/1/012028 [extrait le 2014-04-10]

## Description

La présente invention concerne un système et une méthode de réalisation d'un masque optique pour traitement de surface, notamment pour micro-texturation de surface. L'invention concerne également une installation et une méthode de traitement de surface.

Dans le cadre de l'invention, le masque optique est constitué par des gouttelettes déposées sur une surface exposée à l'environnement extérieur. Selon un premier mode de réalisation, les gouttelettes sont utilisées comme optique de focalisation, pour concentrer un flux lumineux sur la surface. Selon un deuxième mode de réalisation, les gouttelettes sont utilisées comme optique d'occultation, pour faire obstacle à un flux lumineux dirigé sur la surface.

Le domaine de l'invention est celui des méthodes de masquage, ainsi que des méthodes de traitement de surface, notamment de texturation de surface par photolithographie et par gravure laser.

Actuellement, il existe différentes méthodes pour texturer les surfaces. Ces méthodes peuvent être classées en deux catégories, à savoir les méthodes directes d'une part, et les méthodes indirectes impliquant l'utilisation d'un masque d'autre part. Dans ce cas, la structure obtenue correspond au négatif du masque.

Les méthodes de texturation directes peuvent mettre en œuvre un faisceau optique UV, un faisceau d'électrons (« e-beam » en anglais), un faisceau laser, une ionisation par bombardement atomique (FAB ou « Fast Atom Bombardment » en anglais), un faisceau d'ions réactifs (RIBE ou « Reactive Ion Beam Etching » en anglais). Ces méthodes permettent l'obtention de formes complexes et variées par ablation directe d'une surface, mais ne sont pas adaptées à la structuration de grandes surfaces et de substrats non planaires. De plus, ces méthodes présentent un coût généralement élevé. Les publications [1] et [2] ci-après concernent de telles méthodes.

Les méthodes de texturation indirectes peuvent mettre en œuvre des masques d'amplitude, des masques de phase, des nano-billes, la lithographie interférométrique, le démouillage (« dewetting » en anglais). Toutefois, ces méthodes présentent également des inconvénients qui leur sont propres.

Les masques d'amplitude et les masques de phase ont pour principe un contraste d'éclairement de la surface pour obtenir un motif périodique (réseau de diffraction) dans une couche photosensible. Ils peuvent être coûteux pour de petites périodes, de l'ordre micronique ou submicronique (fabrication par faisceau d'électrons) et ne sont pas flexibles en termes de dimensions et de formes des structures obtenues. Les dimensions des structures dépendent des dimensions du masque. Les structures obtenues sont hautement cohérentes, c'est-à-dire qu'elles présentent une période régulière pour la longueur d'onde considérée. Cependant, il est difficile de traiter de larges surfaces. La publication [3] ci-après concerne de telles méthodes.

L'holographie utilise un faisceau laser séparé en deux bras puis recombinés à la surface d'un échantillon recouvert de résine photosensible. L'interférogramme (franges d'intensité périodique) alors formé définit le réseau de diffraction obtenu. L'holographie permet d'agir sur la période de la structure obtenue, mais nécessite l'utilisation d'un laser et d'un montage optique complexe. Il est possible de traiter de larges surfaces, bien que cela nécessite des équipements conséquents. La publication [4] ci-après concerne une telle méthode.

L'utilisation de nano-billes (lithographie colloïdale) focalisant la lumière ou servant de masque permet de texturer de larges surfaces avec une structure périodique. La dimension des billes est néanmoins fixée préalablement. Cette méthode nécessite de disposer d'une machine permettant de déposer des films de type Langmuir-Blodgett. Dans ce cas, le motif est imposé par la taille des billes. La publication [5] ci-après concerne une telle méthode.

Le démouillage permet la formation de nanoparticules métalliques en agissant sur la tension de surface d'une couche de métal noble. La surface est recouverte d'une couche nanométrique de métal noble (or, argent) par dépôt physique en phase vapeur (PVD ou « Physical Vapor Déposition » en anglais). A haute température, la couche déposée forme des nanoparticules de métaux nobles afin de minimiser son énergie de surface. Par conséquent le démouillage n'est pas adapté à la texturation des surfaces sensibles aux températures élevées ou au vide. De plus les particules formées ne mesurent que quelques dizaines de nanomètres. La publication [6] ci-après concerne une telle méthode.

La nano-impression (NIL ou « Nanoimprint lithography » en anglais) utilise un gabarit (ou moule) pour imprimer une forme par pression sur une couche de résine malléable. La forme imprimée est ensuite stabilisée par insolation sous une lampe à ultraviolets ou par refroidissement lent de la couche de résine. Cette étape favorise un durcissement de la résine par réticulation des chaînes polymères. La nano-impression a l'avantage d'être peu coûteuse, cependant une dégradation du gabarit peut être observée après un certain nombre d'utilisations. L'étape de retrait est également sensible et peut laisser apparaître des défauts dans la structure. La publication [7] ci-après concerne une telle méthode.

Les références bibliographiques des publications mentionnées ci-dessus sont les suivantes :
[1] Femtosecond laser-induced mesoporous structures on silicon surface, Xianhua Wang, Feng Chen, Hewei Liu, Weiwei Liang, Qing Yang, Jinhai Si, Xun Hou, Optics Communications 284 (2011) 317-321
[2] Processing study of SU-8 pillar profiles with high aspect ratio by electron-beam lithography, Yaqi Ma, Yifan Xia, Jianpeng Liu, Sichao Zhang, Jinhai Shao, Bing-Rui Lu, Yifang Chen, Microelectronic Engineering 149 (2016) 141-144
[3] Interference lithography at EUV and soft X-ray wavelengths: Principles, methods, and applications, Nassir Mojarad, Jens Gobrecht, Yasin Ekinci, Microelectronic Engineering 143 (2015) 55-63
[4] Optical and Interferometric Lithography - Nanotechnology Enablers, S. R. J. BRUECK, FELLOW, PROCEEDINGS OF THE IEEE, VOL. 93, NO. 10, OCTOBER 2005
[5] Plasmonic films based on colloidal lithography, Bin Ai, Ye Yu, Helmuth Möhwald, Gang Zhang, Bai Yang, Advances in Colloid and Interface Science 206 (2014) 5-16
[6] Fabrication of hollow gold nanoparticles by dewetting, dealloying and coarsening, Anna Kosinova , Dong Wang, Peter Schaaf, Oleg Kovalenko, Leonid Klinger, Eugen Rabkin, Acta Materialia 102 (2016) 108-115
[7] Recent Advances in Nano Patterning and Nano Imprint Lithography for Biological Applications, N.Vigneswaran, Fahmi Samsuri, Balu Ranganathan, Padmapriya, Procedia Engineering 97 (2014) 1387 - 1398

Les méthodes de texturation décrites ci-dessus présentent différents inconvénients. Ces méthodes sont relativement coûteuses et/ou mal adaptées à des supports en trois dimensions et/ou complexes à mettre en œuvre. Par ailleurs, ces méthodes sont généralement prévues pour des applications nécessitant des profils de micro-texturation réguliers, qui présentent des périodicités et des alignements très précis. Cependant, cette régularité n'est pas indispensable pour toutes les applications. Ainsi, la sur-qualité et donc le surcoût induit par ces méthodes peut faire obstacle à leur mise en œuvre dans de nouvelles applications. En outre, certaines applications nécessitent au contraire une très grande distribution spatiale (en taille et périodicité).

EP 0 759 578 A1 décrit un système de réalisation d'un masque optique selon le préambule de la revendication 1. Ce système comprend une couche de matière photosensible, et un dispositif de génération et dépôt de gouttelettes sur la surface externe de la couche de matière. L'agencement et la taille des gouttelettes sont contrôlées par un contrôle de l'atmosphère de vapeur d'eau et de la température de la surface externe de la couche de matière.

Le but de la présente invention est de proposer des systèmes et méthodes améliorés de réalisation d'un masque, ainsi que de traitement d'une surface.

A cet effet, l'invention a pour objet un système de réalisation d'un masque optique pour traitement de surface, notamment pour micro-texturation de surface, le système comprenant : une couche de matière comportant une surface externe exposée à l'environnement extérieur ; et un dispositif de génération et dépôt de gouttelettes sur la surface externe de la couche de matière, selon un agencement particulier, formant le masque optique sur la surface externe de la couche de matière ; caractérisé en ce que la surface externe de la couche de matière est initialement traitée pour définir des sites de fixation préférentiels des gouttelettes, permettant ainsi de maîtriser l'agencement des gouttelettes formant le masque optique sur la surface externe.

Ainsi, en utilisant les gouttelettes comme optique de concentration ou d'occultation, l'invention permet de réaliser un masque pour un coût très faible en comparaison avec la plupart des méthodes existantes. Les gouttelettes sont faciles à former, puis à nettoyer. L'invention ne nécessite pas la mise en œuvre de dispositifs de positionnement de systèmes optiques avec une précision submicronique, ni la mise en œuvre d'une machine de Langmuir-Blodgett. L'invention permet également d'éviter les problèmes de dégradation du moule propres aux technologies de nano-impression. Contrairement au démouillage, l'invention ne nécessite pas de recuit problématique pour les matériaux sensibles aux hautes températures.

En outre, l'invention permet de traiter de grandes surfaces, ainsi que différentes formes de substrats : courbé, sphérique, parabolique, cylindro-circulaire ou toute autre géométrie complexe.

La présente invention peut trouver des applications dans de nombreux domaines techniques : photolithographie, optique, mécanique, électromagnétisme, tribologie, chimie, biologie, etc. En optique, ces applications concernent notamment le piégeage optique, la diffusion de la lumière, la fabrication de corps noir, l'anti-reflet. En mécanique des fluides, ces applications concernent notamment l'hydrodynamique, l'effet peau de requin, l'effet balle de golf, la couche limite turbulente. En tribologie, une application concerne la lubrification des interfaces de contact. En chimie, une application concerne l'augmentation de la surface spécifique dans le cadre d'une catalyse, ou encore la réalisation de capteurs à effets SERS (« surface enhanced raman scattering » en anglais). D'autres applications concernent la mouillabilité des surfaces, l'hydrophobie, etc.

Par ailleurs, l'invention peut être mise en œuvre dans le cadre de traitements de surface autres que la micro-texturation, où les gouttelettes peuvent être avantageusement utilisées comme optique de concentration ou d'occultation. De tels traitements consistent à modifier les propriétés d'une surface pour sa fonctionnalisation, sans nécessairement modifier son relief. Par exemple, ces traitements peuvent modifier les propriétés optiques (indice de réfraction), mécaniques (dureté, résistance à l'abrasion) chimique (mouillabilité, sites de fixation préférentiels de molécules) ou électriques (résistivité) de la surface.

Selon d'autres caractéristiques avantageuses du système de réalisation d'un masque optique selon l'invention, prises isolément ou en combinaison :
- Le dispositif de génération et dépôt comprend une enceinte fermée, ayant une atmosphère gazeuse présentant une température et une humidité contrôlées, de sorte que les gouttelettes se condensent de manière contrôlée sur la surface externe de la couche de matière.
- Le dispositif de génération et dépôt comprend une unité de refroidissement d'une surface inférieure de la couche de matière.
- Le dispositif de génération et dépôt comprend une unité de contrôle par imagerie de l'agencement des gouttelettes sur la surface externe de la couche de matière.
- Le système comprend un dispositif de prétraitement de la couche de matière, conçu pour définir des sites de fixation préférentiels des gouttelettes à la surface externe de la couche de matière, permettant ainsi de maîtriser l'agencement des gouttelettes formant le masque optique sur la surface externe. Autrement dit, la surface externe de la couche de matière est initialement traitée (c'est-à-dire traitée avant introduction de la couche de matière dans le dispositif de génération et dépôt de gouttelettes) pour définir les sites de fixation préférentiels.
- Les sites de fixation préférentiels sont répartis sur la surface externe de sorte que l'agencement des gouttelettes est régulier.
- Le système comprend un substrat comportant une surface recouverte par la couche de matière.
- La couche de matière est perméable au flux lumineux, et le système comprend un substrat comportant une surface disposée en regard de la couche de matière. Dans ce cas, la couche de matière peut être positionnée sur le substrat, ou bien écartée par rapport au substrat.
- Les gouttelettes sont constituées d'eau, d'une solution aqueuse, d'huile, de polymère liquide (par exemple de silicone) ou de métal.

L'invention a également pour objet une installation de traitement de surface, notamment de micro-texturation de surface.

Selon un mode de réalisation particulier, l'installation de traitement comprend : un système de réalisation d'un masque optique tel que mentionné ci-dessus ; et un dispositif de traitement localisé de la couche de matière, en fonction de l'agencement des gouttelettes formant le masque optique sur la surface externe, à travers le masque optique formé par ces gouttelettes sur la couche de matière. La localisation du traitement dépend de l'agencement des gouttelettes formant le masque optique. Le traitement est réalisé à travers ce masque optique.

Dans le cas d'une installation de micro-texturation de surface, le dispositif de traitement localisé de la couche de matière est un dispositif de retrait localisé en fonction de l'agencement des gouttelettes sur la surface externe, à travers le masque optique formé par ces gouttelettes sur la couche de matière.

Selon un autre mode de réalisation particulier, l'installation de traitement comprend : un système de réalisation d'un masque optique tel que mentionné ci-dessus, comprenant un substrat comportant une surface recouverte par la couche de matière ; un dispositif de retrait localisé de la couche de matière, en fonction de l'agencement des gouttelettes sur la surface externe, à travers le masque optique formé par ces gouttelettes sur la couche de matière, laquelle comporte alors des zones de retrait et des zones de matière formant un second masque sur le substrat ; et un dispositif de traitement localisé de la surface du substrat à travers le second masque formé par la couche de matière sur le substrat.

Selon un autre mode de réalisation particulier, l'installation de traitement comprend : un système de réalisation d'un masque optique tel que mentionné ci-dessus, comprenant une couche de matière perméable au flux lumineux, et un substrat comportant une surface disposée en regard de la couche de matière ; et un dispositif de traitement localisé du substrat, en fonction de l'agencement des gouttelettes formant le masque optique sur la surface externe de la couche de matière, à travers le masque optique formé sur la couche de matière perméable au flux lumineux.

Dans le cas d'une installation de micro-texturation de surface, le dispositif de traitement localisé de la surface du substrat est un dispositif de retrait localisé en fonction de l'agencement des gouttelettes sur la surface externe, à travers le masque optique formé par ces gouttelettes sur la couche de matière.

Dans le cas où le substrat est réalisé en matériau photosensible, le dispositif de traitement localisé du substrat comprend, d'une part, une unité d'insolation émettant un flux lumineux qui traverse les gouttelettes et atteint la surface du substrat et, d'autre part, une unité de développement du substrat après exposition au flux lumineux.

Selon d'autres caractéristiques avantageuses de l'installation de traitement selon l'invention, prises isolément ou en combinaison :
- La couche de matière est réalisée en matériau photosensible et le dispositif de traitement localisé de la couche de matière comprend, d'une part, une unité d'insolation émettant un flux lumineux qui traverse les gouttelettes et atteint la surface externe de la couche de matière et, d'autre part, une unité de développement de la couche de matière après exposition au flux lumineux.
- La couche de matière est réalisée en matériau photosensible positif, de sorte que les zones de traitement de la couche de matière sont situées directement sous les gouttelettes.
- La couche de matière est réalisée en matériau photosensible négatif, de sorte que les zones de traitement de la couche de matière sont situées autour et entre les gouttelettes.
- Le dispositif de traitement localisé est un dispositif de micro-texturation, comprenant par exemple une unité de gravure ionique réactive, une unité de gravure chimique ou une unité de gravure optique.

L'invention a également pour objet une méthode de réalisation d'un masque optique pour traitement de surface, notamment pour micro-texturation de surface. Cette méthode comprend les étapes suivantes : une étape de fourniture d'une couche de matière comportant une surface externe exposée à l'environnement extérieur ; une étape de prétraitement de la couche de matière, le prétraitement définissant des sites de fixation préférentiels de gouttelettes à la surface externe de la couche de matière, permettant ainsi de maîtriser l'agencement des gouttelettes formant le masque optique sur la surface externe ; et une étape de génération et de dépôt de gouttelettes sur la surface externe de la couche de matière, selon un agencement particulier, formant ainsi le masque optique sur la surface externe de la couche de matière.

L'invention a également pour objet une méthode de traitement de surface.

Selon un mode de réalisation particulier, la méthode de traitement de surface comprend les étapes successives suivantes :
a) une étape de fourniture d'une couche de matière comportant une surface externe exposée à l'environnement extérieur ;
b) une étape de prétraitement de la couche de matière, le prétraitement définissant des sites de fixation préférentiels de gouttelettes à la surface externe de la couche de matière, permettant ainsi de maîtriser l'agencement des gouttelettes formant un masque optique sur la surface externe ;
c) une étape de génération et dépôt de gouttelettes sur la surface externe de la couche de matière, selon un agencement particulier, formant ainsi le masque optique sur la surface externe de la couche de matière ; et
d) une étape de traitement localisé de la couche de matière en fonction de l'agencement des gouttelettes sur la surface externe, à travers le masque optique formé sur la couche de matière.

Dans ce mode de réalisation, l'étape de traitement localisé de la couche de matière peut être une étape de retrait localisé de la couche de matière. Ainsi, la méthode de traitement de surface constitue une méthode de micro-texturation de la surface externe de la couche de matière.

Selon un autre mode de réalisation particulier, la méthode de traitement de surface comprend les étapes successives suivantes :
a) une étape de fourniture d'un substrat ayant une surface recouverte par une couche de matière, qui comporte une surface externe exposée à l'environnement extérieur ;
b) une étape de prétraitement de la couche de matière, le prétraitement définissant des sites de fixation préférentiels de gouttelettes à la surface externe de la couche de matière, permettant ainsi de maîtriser l'agencement des gouttelettes formant un masque optique sur la surface externe ;
c) une étape de génération et dépôt de gouttelettes sur la surface externe de la couche de matière, selon un agencement particulier, formant ainsi le masque optique sur la surface externe de la couche de matière ;
d) une étape de retrait localisé de la couche de matière en fonction de l'agencement des gouttelettes sur la surface externe, à travers le masque optique formé sur la couche de matière, laquelle comporte alors des zones de retrait et des zones de matière formant un second masque sur le substrat ; et
e) une étape de traitement localisé de la surface du substrat à travers le second masque formé par la couche de matière sur le substrat.

Dans ce mode de réalisation, l'étape de traitement localisé de la surface du substrat peut être une étape de retrait localisé de la surface du substrat. Ainsi, la méthode de traitement de surface constitue une méthode de micro-texturation de la surface du substrat.

Selon un autre mode de réalisation particulier, la méthode de traitement de surface comprend les étapes successives suivantes :
a) une étape de fourniture d'une couche de matière perméable au rayonnement lumineux et comportant une surface externe exposée à l'environnement extérieur ;
b) une étape de prétraitement de la couche de matière, le prétraitement définissant des sites de fixation préférentiels de gouttelettes à la surface externe de la couche de matière, permettant ainsi de maîtriser l'agencement des gouttelettes formant un masque optique sur la surface externe ;
c) une étape de fourniture d'un substrat ayant une surface disposée en regard de la couche de matière ;
d) une étape de génération et dépôt de gouttelettes sur la surface externe de la couche de matière, selon un agencement particulier, formant ainsi le masque optique sur la surface externe de la couche de matière ;
e) une étape de traitement localisé de la surface du substrat à travers le masque optique formé par les gouttelettes sur la couche de matière.

Au cours de l'étape de traitement e), un déplacement relatif peut être effectué entre la surface du substrat et la couche de matière supportant les gouttelettes qui forment le masque optique, de manière à reproduire régulièrement sur la surface du substrat un motif défini par le masque optique.

En cas de besoin, l'étape de génération et dépôt de gouttelettes est répétée plusieurs fois pour modifier l'agencement des gouttelettes formant le masque optique, avant la réalisation de l'étape suivante de traitement (retrait ou autre) localisé de la couche de matière ou du substrat.

Selon d'autres caractéristiques avantageuses des méthodes selon l'invention, prises isolément ou en combinaison :
- Dans l'étape de fourniture, la couche de matière est positionnée dans une enceinte fermée, ayant une atmosphère gazeuse présentant une température et une humidité contrôlées, et dans l'étape de génération et de dépôt, les gouttelettes se condensent sur la surface externe de la couche de matière.
- Dans l'étape de génération et de dépôt, les gouttelettes sont pulvérisées sur la surface externe de la couche de matière.
- Dans l'étape de génération et de dépôt, les gouttelettes sont déposées par gravité sur la surface externe de la couche de matière.
- La couche de matière est réalisée en matériau photosensible, et l'étape de traitement localisé de la couche de matière met en œuvre, dans un premier temps, une sous-étape d'insolation de la couche de matière à travers les gouttelettes et, dans un second temps, une sous-étape de développement de la couche de matière après insolation.
- La couche de matière est réalisée en matériau photosensible positif, de sorte que les zones de traitement localisé de la couche de matière sont situées directement sous les gouttelettes.
- La couche de matière est réalisée en matériau photosensible négatif, de sorte que les zones de traitement localisé de la couche de matière sont situées autour et entre les gouttelettes.

L'invention sera mieux comprise à la lecture de la description qui va suivre, donnée uniquement à titre d'exemple non limitatif et faite en référence aux dessins annexés sur lesquels :
- la figure 1 est une vue de dessus d'un substrat comportant une surface texturée conformément à l'invention ;
- la figure 2 est un graphe montrant les avantages de l'invention dans le cadre d'une application solaire thermique ;
- les figures 3 à 9 sont des coupes montrant différents éléments constitutifs d'une installation de micro-texturation de surface conforme à l'invention, mettant en œuvre une résine photosensible positive, et des gouttelettes de focalisation ayant des formes et dimensions variables ainsi qu'une répartition spatiale irrégulière ;
- la figure 10 est une coupe analogue à la figure 6, à plus grande échelle, en considérant une unique gouttelette ;
- la figure 11 est un graphe illustrant l'évolution de la réflectance en fonction de l'angle d'incidence à l'interface air/eau ;
- la figure 12 est une coupe analogue à la figure 7, à plus grande échelle, montrant la résine de la figure 10 après développement ;
- la figure 13 est une vue en perspective de la résine de la figure 12 ;
- la figure 14 est une vue de dessus d'un autre exemple de substrat comportant une surface texturée conformément à l'invention ;
- la figure 15 est une coupe transversale d'une cavité formée sur la surface texturée de la figure 14 ;
- les figures 16 et 17 sont analogues respectivement aux figures 14 et 15, pour un autre exemple de substrat comportant une surface texturée conformément à l'invention ;
- la figure 18 est une vue en perspective, obtenue à l'aide d'un profilomètre tactile, d'un autre exemple de substrat comportant une surface texturée conformément à l'invention ;
- les figures 19 à 22 sont des coupes analogues respectivement aux figures 6 à 9, pour une variante de l'invention mettant en œuvre une résine photosensible négative ;
- les figures 23 à 25 sont des coupes analogues respectivement aux figures 6, 7 et 9, pour une variante de l'invention mettant en œuvre des gouttelettes d'occultation ;
- les figures 26 à 32 sont des coupes analogues respectivement aux figures 3 à 9, pour une variante de l'invention mettant en œuvre un agencement régulier de gouttelettes de même forme et mêmes dimensions ;
- les figures 33 à 35 sont des coupes analogues respectivement aux figures 27, 29 et 32, pour une variante de l'invention mettant en œuvre une couche de matière à texturer non déposée sur un substrat ;
- les figures 36 à 38 sont des coupes analogues respectivement aux figures 33 à 35, illustrant une méthode de traitement de surface autre qu'une micro-texturation ;
- les figures 39 et 40 sont des coupes analogues respectivement aux figures 6 et 7, pour une variante de l'invention mettant en oeuvre un faisceau oblique ;
- la figure 41 est une coupe analogue à la figure 39, à plus grande échelle ;
- les figures 42 et 43 sont des coupes analogues respectivement aux figures 39 et 40, pour une variante de l'invention mettant en œuvre un faisceau oblique, incliné selon deux directions opposées à 180° ;
- la figure 44 est une vue de dessus de la couche de résine après développement, selon la flèche XLIV à la figure 43 ;
- la figure 45 est une vue analogue à la figure 39, à plus petite échelle, montrant un exemple d'unité d'insolation 51 ;
- la figure 46 présente différentes photographies réalisées au microscope électronique à balayage, montrant différents exemples de couches de résine après insolation sous faisceau oblique puis développement ;
- les figures 47 et 48 sont des coupes analogues respectivement aux figures 6 et 7, pour une variante de l'invention mettant en œuvre un masque préliminaire ;
- la figure 49 est une vue de dessus de la couche de résine après développement, selon la flèche XLIX à la figure 48 ;
- les figures 50 et 51 sont des coupes analogues respectivement aux figures 6 et 7, pour une variante de l'invention où la couche de matière est perméable au flux lumineux ; et
- les figures 52 et 53 sont des coupes analogues respectivement aux figures 50 et 51, pour une variante de l'invention où la couche de matière est perméable au flux lumineux et est disposée sous le substrat.

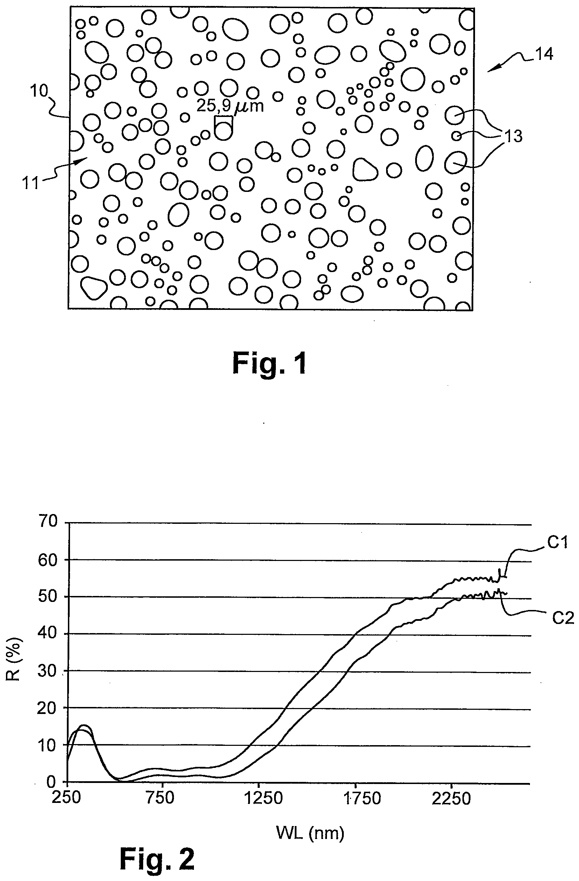

La figure 1 montre un substrat 10 comportant une surface 11 micro-texturée en mettant en œuvre l'invention.

Le substrat 10 comporte des cavités 13 de formes et dimensions variables, ouvertes au niveau de la surface 11. Les cavités 13 présentent des largeurs, définies parallèlement à la surface 11, de l'ordre de quelques dizaines de micromètres, par exemple 25,9 µm pour l'une des cavités 13 montrée sur la figure 1.

Les cavités 13 forment ensemble un profil de micro-texturation 14 irrégulier à la surface 11 du substrat 10. La méthode de micro-texturation de la surface 11, consistant à ménager les cavités 13 dans le substrat 10, et ainsi former le profil de micro-texturation 14 à la surface 11, est détaillée par la suite.

La figure 2 montre un exemple d'utilisation du substrat 10 comportant un profil de micro-texturation 14 irrégulier, à savoir la fabrication d'un absorbeur spectralement sélectif pour une application solaire thermique.

Sur le graphe de la figure 2, l'axe des abscisses représente une longueur d'onde WL en nanomètres, tandis que l'axe des ordonnées représente une réflectance R en pourcentage. La courbe C1 correspond à un absorbeur solaire déposé sur une surface plane, tandis que la courbe C2 correspond à un absorbeur solaire identique déposé sur la surface 11 présentant le profil de micro-texturation 14 irrégulier montré à la figure 1. Dans cet exemple, l'absorbeur est en TiAIN (nitrure de titane-aluminium).

En comparaison avec l'absorbeur plan, on observe que l'absorbeur texturé présente une meilleure absorption du spectre solaire dans les longueurs d'ondes visibles (380-700 nm) et proche infrarouge (700-2500 nm). L'absorption est définie comme l'intégrale de l'absorbance sur la gamme de longueurs d'ondes considérée ci-dessus (380-2500 nm).

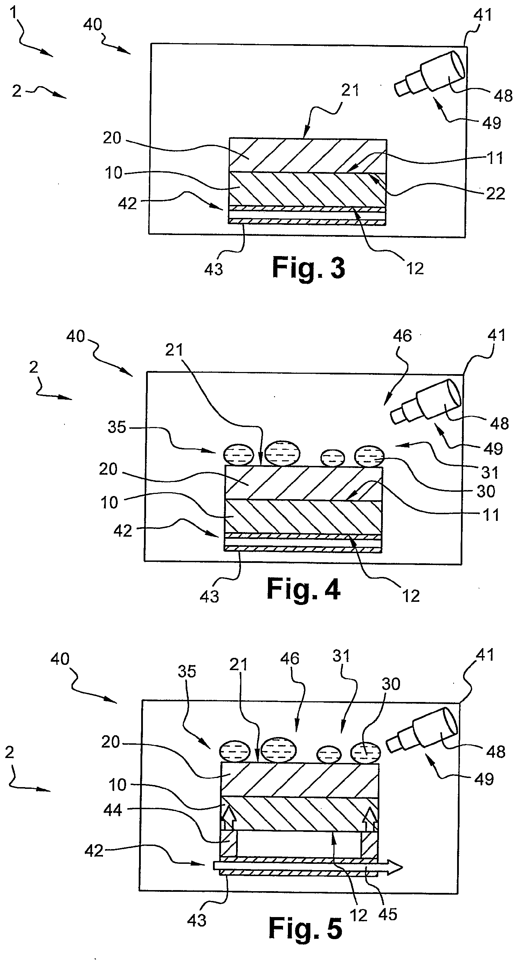

Les figures 3 à 9 montrent différents éléments constitutifs d'une installation de micro-texturation 1 conforme à l'invention, mise en oeuvre pour texturer la surface 11 du substrat 10. L'installation 1 comprend différents dispositifs 40, 50 et 60.

Au sein de l'installation 1, l'invention concerne en particulier un système 2 de réalisation d'un masque optique 35 constitué par un agencement 31 de gouttelettes 30, comme détaillé par la suite. Le système 2 comprend le dispositif 40.

Sur l'exemple des figures 3 à 8, le substrat 10 présente une forme parallélépipédique. Le substrat 10 comporte une surface supérieure 11 et une surface inférieure 12, planes et parallèles entre elles.

En alternative, le substrat 10 peut présenter toute forme adaptée à l'application visée, par exemple une forme tubulaire.

A titre d'exemples, le substrat 10 peut être réalisé en silicium, verre, polymère, métal, etc.

Le substrat 10 comporte également une couche de matière 20 recouvrant la surface 11 à texturer. Ce recouvrement de la surface 11 par la couche 20 peut être complet ou partiel. La couche 20 peut être déposée à la surface 11 du substrat 10 par tout moyen adapté, par exemple par enduction centrifuge (« *spin coating* » en anglais). La couche 20 est de préférence réalisée en matériau photosensible, par exemple en matériau polymère tel que la résine S1805, qui est relativement hydrophobe. Le caractère hydrophobique du matériau de la couche 20 influence la formation des gouttelettes 30.

A titre d'exemple, le substrat 10 présente une épaisseur de l'ordre de 1 à 2 mm, tandis que la couche 20 présente une épaisseur de l'ordre de 100 nm à 500 nm. Sur les figures, ces épaisseurs sont représentées avec un même ordre de grandeur dans un but de simplification.

La couche 20 comporte une surface supérieure 21 et une surface inférieure 22. La surface 21 peut être qualifiée de surface externe, dans la mesure où elle est exposée à l'environnement extérieur, tandis que la surface 22 peut être qualifiée de surface interne, dans la mesure où elle est positionnée contre la surface 11, et donc agencée entre la couche 20 et le substrat 10.

La surface 21 peut recevoir un prétraitement chimique pour modifier sa mouillabilité, en tout ou partie, par exemple en utilisant un procédé plasma ou par voie humide.

La surface 21 peut recevoir un prétraitement de fonctionnalisation permettant de définir des sites de fixation préférentiels des gouttelettes 30. Le prétraitement de fonctionnalisation peut être réalisé par laser, plasma, insolation ou tout autre moyen approprié. Par exemple, on réalise un prétraitement chimique modifiant localement la mouillabilité de la surface 21, ou bien on réalise un balayage de la surface 21 en générant des impulsions lasers, selon un motif régulier ou irrégulier.

Les figures 3 à 5 montrent le substrat 10 positionné dans un dispositif de génération et dépôt 40, prévu pour générer des gouttelettes 30 puis les déposer à la surface 21 de la couche 20.

Le dispositif 40 comprend une enceinte fermée 41 et une unité de refroidissement 42 disposée dans l'enceinte 41. Le substrat 10 revêtu de la couche 20 est initialement disposé sur l'unité 42, de sorte que les surfaces 11 et 21 sont dirigées vers le haut. L'enceinte 41 a une atmosphère 46 gazeuse présentant une température et une humidité contrôlées.

L'unité 42 permet de refroidir la surface inférieure 12 du substrat 10, puis la surface 21, par conduction thermique. En jouant sur la différence de températures entre la surface 21 et l'atmosphère 46 de l'enceinte 41, il est possible de produire de la condensation à partir du gaz présent dans l'atmosphère 46, si la pression partielle de ce gaz dans l'enceinte 41 est suffisante. Généralement le gaz présent dans l'atmosphère 46 est de la vapeur d'eau, mais d'autres gaz peuvent être utilisés, comme par exemples des vapeurs d'huile ou de silicone.

L'unité 42 comprend un support 43 et des pieds rétractables 44. Le support 43 est une plaque métallique, traversée par un flux d'eau froide 45 présentant une température contrôlée. Par exemple, le flux 45 a une température de l'ordre de 5 °C. En alternative, le flux 45 peut être constitué par un autre fluide adapté à l'application visé, tel que de l'eau glycolée ou de l'azote liquide. Les échanges thermiques peuvent être améliorés en polissant le support 43 et/ou en disposant une pellicule d'eau entre la surface 12 et le support 43. Les pieds 44 peuvent être actionnés pour mettre la surface 12 du substrat 10 au contact du support 43, comme sur la figure 4, ou pour écarter cette surface 12 du support 43, comme sur la figure 5.

Lorsque la surface 12 est positionnée contre le support 43, la température du substrat 10 puis de la couche 20 diminue. Le refroidissement de la surface 21 augmente la condensation des gouttelettes 30. Lorsque l'agencement 31 des gouttelettes 30 est satisfaisant, les pieds 44 sont actionnés pour écarter le substrat 10 du support 43 et stopper la condensation. Ainsi, l'unité 42 permet de contrôler la condensation des gouttelettes 30 sur la surface 21. L'agencement 31 est considéré comme satisfaisant lorsque les formes, dimensions et répartition des gouttelettes 30 sont conformes aux critères prédéfinis en fonction de l'application visée. Par exemple, dans le cas de l'application solaire thermique illustrée aux figures 1 et 2, l'obtention de gouttelettes 30 ayant une taille de l'ordre de quelques dizaines de micromètres et une répartition de l'ordre de 50 à 150 gouttelettes par mm² constitue deux critères à satisfaire. Les critères sont définis au cas par cas pour chaque application.

Le dispositif 40 comprend également une unité 48 de contrôle de l'agencement 31 des gouttelettes 30 sur la surface 21. L'unité 48 comprend par exemple une caméra laser 49, un microscope, une loupe binoculaire ou tout autre système d'imagerie. L'unité 48 permet de contrôler la condensation des gouttelettes 30 in situ, directement dans l'enceinte 41. Ainsi, l'arrêt de la condensation des gouttelettes 30 est grandement facilité, lorsque l'agencement 31 est conforme au résultat souhaité concernant les formes, dimensions et répartition des gouttelettes 30.

Les gouttelettes 30 se condensent sur la surface 21 selon un agencement spatial 31, irrégulier et aléatoire. Plus précisément, les gouttelettes 30 présentent des formes et dimensions variables, ainsi qu'une répartition spatiale irrégulière.

L'agencement 31 des gouttelettes 30 peut être modifié en jouant sur différents facteurs, tels que l'amplitude de la différence de températures entre la surface 21 et l'atmosphère 46, la pression partielle de la vapeur d'eau et donc l'humidité relative dans l'enceinte 41, la durée de la condensation, les prétraitements appliqués sur la surface 21 avant dépôt des gouttelettes 30, etc.

Après dépôt et condensation, les gouttelettes 30 réparties selon l'agencement 31 forment le masque optique 35 sur la surface 21 de la couche 20. Le substrat 10 comportant la couche 20 et les gouttelettes 30 peut alors être retiré de l'enceinte 41.

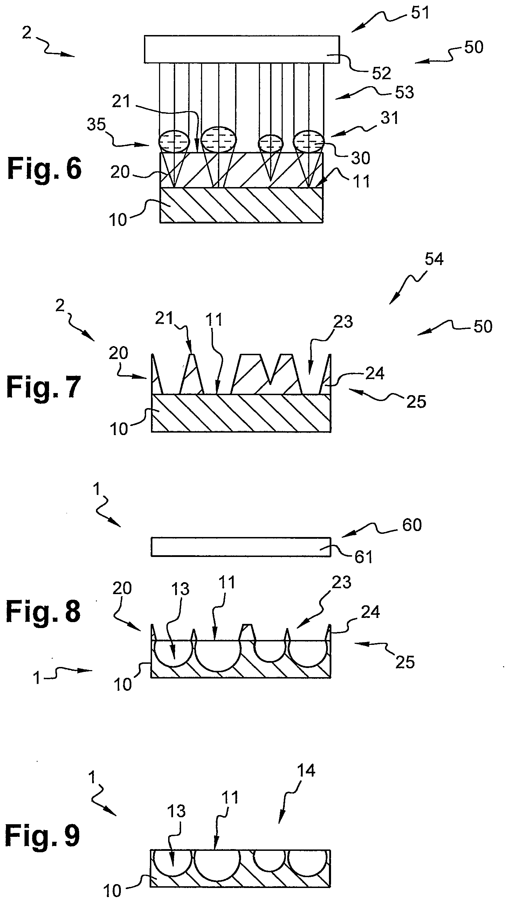

Les figures 6 et 7 montrent un dispositif 50 de retrait localisé de la couche de matière 20, en fonction de l'agencement 31 des gouttelettes 30 sur la surface 21, pour former un masque 25 sur le substrat 10. Plus précisément, l'étape de retrait localisé de la couche 20 comprend une sous-étape d'insolation montrée à la figure 6, et une sous-étape de développement montrée à la figure 7. Le dispositif 50 comprend une unité d'insolation 51 et une unité de développement 54.

La figure 6 montre l'unité d'insolation 51 comprenant une source lumineuse 52, par exemple une lampe à rayonnement ultraviolet. La source 52 émet un flux lumineux 53 qui traverse les gouttelettes 30 pour atteindre la surface 21. A ce stade, chacune des gouttelettes 30 constitue une lentille asphérique convexe concentrant localement le flux lumineux 53. La distance focale de chaque lentille dépend de la forme de la gouttelette 30. La couche de matière 20 en résine photosensible est affectée par le faisceau lumineux 53 focalisé par les gouttelettes 30, qui augmentent localement la dose d'insolation reçue.

Sur l'exemple des figures 6 à 9, la couche 20 est réalisée en résine photosensible positive, et les gouttelettes 30 remplissent une fonction d'optique de concentration du flux lumineux 53. Les zones de la couche 20 exposées au faisceau 53 deviennent solubles au développement, tandis que les zones de la couche 20 peu ou pas exposées restent insolubles.

Après insolation, le substrat 10 et la couche 20 sont séchés à l'azote, puis transférés vers l'unité de développement 54. La technique de développement dépend de la matière de la couche 20. Par exemple, dans le cas où la couche 20 est en résine S1805, le développement consiste à tremper la couche dans une solution MF319 comprenant environ 97 à 98% d'eau et 2,45% d'hydroxyde de tetramethylammonium.

Afin d'obtenir un profil 14 présentant une densité de motifs plus importante à la surface 11, il est possible d'effectuer plusieurs cycles de condensation, insolation et séchage avant le développement.

La figure 7 montre la couche de matière 20 après développement par l'unité 54. La couche 20 comporte alors des zones 23 de retrait de matière et des zones 24 de matière restante. La couche 20 forme ainsi le masque 25, qui est agencé sur le substrat 10. Les zones 23 et 24 présentent des dimensions variables, résultant de l'agencement 31 irrégulier des gouttelettes 30 de la figure 6.

Sur l'exemple de la figure 7, la couche 20 est réalisée en résine photosensible positive. Les zones 23 sont situées directement sous les gouttelettes 30 de la figure 6 sous forme de trous, tandis que les zones 24 sont situées autour et entre les gouttelettes 30 de la figure 6.

La figure 8 montre un dispositif 60 de micro-texturation de la surface 11 à travers le masque 25. L'agencement des cavités 13, et donc le profil de micro-texturation 14 formé à la surface 11, dépendent de l'agencement des zones 23 et 24 de la couche 20 formant le masque 25. La micro-texturation peut être réalisée par voie humide, par voie sèche ou ablation laser, en fonction notamment du matériau du substrat 10 et de l'application visée.

Sur l'exemple de la figure 8, le dispositif 60 comporte une unité 61 de gravure ionique réactive. En alternative, le dispositif peut comporter une unité de gravure chimique, une unité de gravure optique (ablation) ou toute autre unité de gravure adaptée à l'application visée. Par exemple, lorsque le substrat 10 est en aluminium, la surface 11 peut être gravée par immersion dans un mélange d'acide phosphorique et d'acide nitrique (Transene Aluminum Etchant Type A ©).

Après gravure, les résidus de résine de la couche 20 peuvent être retirés selon différentes méthodes, par exemple par immersion dans de l'acétone, ou par agitation ultrasons. La méthode choisie dépend notamment des matériaux du substrat 10 et de la couche 20.

La figure 9 montre le substrat 10 final, comportant les cavités 13 réparties selon le profil de micro-texturation 14. Comme l'agencement 31 des gouttelettes 30 était irrégulier, les cavités 13 présentent des formes, des dimensions et une répartition irrégulières.

Un exemple pratique de mise en œuvre de l'invention est défini ci-après. Cet exemple concerne la fabrication d'un absorbeur spectralement sélectif pour une application solaire thermique.

Les résultats des figures 1 et 2 sont obtenus en mettant en œuvre l'installation 1 des figures 3 à 9 avec les paramètres suivants :
- Le substrat 10 est en inox 304L et présente une forme parallélépipédique, avec une épaisseur de 1 mm, une longueur de 50 mm et une largeur de 50 mm.
- La couche 20 est en résine photosensible S1805 et présente une épaisseur de 300 nm.
- La couche 20 est déposée à la surface 11 du substrat 10 par enduction centrifuge.
- L'enceinte 41 a une hauteur de 300 mm, une longueur de 200 mm et une largeur de 200 mm.
- Le support 43 est en acier. Sa surface supérieure n'est pas polie et ne reçoit pas de pellicule d'eau avant de recevoir le substrat 10.
- Le flux 45 d'eau froide circule dans le support à une température de 5 °C.
- L'atmosphère 46 dans l'enceinte 41 présente initialement une température de 25 °C et une humidité de 50%.
- Les gouttelettes 30 formées sur la surface 21 de la couche 20 par condensation dans l'enceinte 41 sont constituées d'eau, ayant un indice de réfraction de l'ordre de 1,33. Ces gouttelettes 30 ont une forme de demi-ellipse, une taille comprise entre 10µm et 50µm, et une distribution de l'ordre de 160 à 400 gouttelettes 30 par 1 mm².
- La source lumineuse 52 est une lampe à rayonnement ultraviolet, émettant sur une longueur d'onde comprise entre 365 et 435 nm. La puissance de la lampe est de 100W. La durée d'exposition de la couche 20 est de 10 secondes.
- L'unité de développement 54 met en œuvre une solution MF319 comprenant environ 97 à 98% d'eau et 2,45% d'hydroxyde de tetramethylammonium, dans laquelle est trempée la couche 20 après insolation par le flux lumineux 53. Le développement dure quelques secondes.
- Le dispositif de micro-texturation 60 comprend une unité 61 de gravure ionique réactive.
- Après gravure, les résidus de résine de la couche 20 sont retirés du substrat 10 par immersion dans de l'acétone.
- Les cavités 13 formées à la surface 11 du substrat 10 présentent des largeurs et profondeurs de l'ordre de quelques dizaines de micromètres.

L'installation 1 de micro-texturation de surface 11 et le système 2 de réalisation du masque optique 35 peuvent être conformés différemment des figures 3 à 9 sans sortir du cadre de l'invention.

Par exemple, au lieu de la condensation, le dispositif 40 de génération et dépôt de gouttelettes 30 peut fonctionner par pulvérisation, par gravité ou par toute autre méthode adaptée.

Selon un autre exemple, le substrat 10 et la couche 20 peuvent être positionnés en sens inverse, de sorte que le substrat 10 est en dessus et la couche 20 est en dessous. Le substrat 10 revêtu de la couche 20 est initialement disposé dans le dispositif 40, de sorte que les surfaces 11 et 21 sont dirigées vers le bas. Les gouttelettes 30 forment le masque optique 35 sur la surface externe 21 de la couche 20.

En fonction du liquide constituant les gouttelettes 30, obtenues par condensation d'un gaz dans l'enceinte 41, les gouttelettes 30 sont susceptibles de remplir une fonction d'optique de concentration ou d'occultation du flux lumineux 53 dans le dispositif 50.

Les gouttelettes 30 peuvent être constituées d'eau, d'une solution aqueuse, d'huile, de polymère liquide (tel que le silicone), de métal, etc.

La composition des gouttelettes 30 modifie leur indice optique de réfraction permettant de changer la focalisation dans le cas d'une optique de concentration. Egalement, la composition des gouttelettes 30 modifie leur tension de surface sur la couche 20, permettant une modification des formes, des dimensions et la distribution dimensionnelle des gouttelettes 30.

Le tableau ci-après indique différentes compositions des gouttelettes 30 et les indices de réfraction correspondants :

| LIQUIDE | INDICE DE REFRACTION |
|---|---|
| Eau | 1,33 |
| Acétone | 1,36 |
| Glycérine | 1,47 |
| Benzène | 1,5 |
| Huile de silicone | 1,33-1,58 |
| Chlorure de sodium | 1,54 |
| Ethanol | 1,36 |
| 10% de glucose dans l'eau | 1,348 |
| 20% de glucose dans l'eau | 1,363 |
| 30% de glucose dans l'eau | 1,439 |

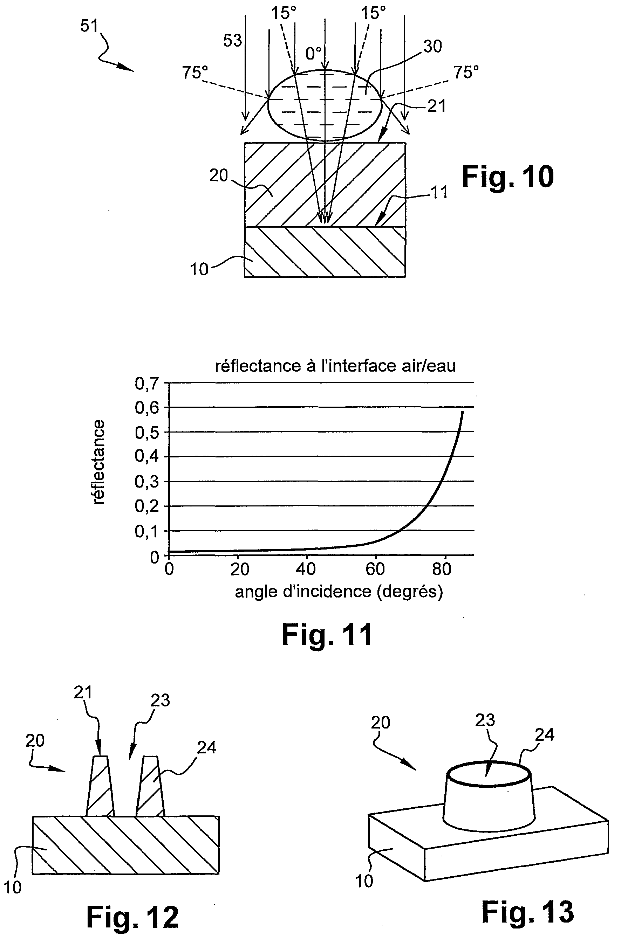

Les figures 10 à 13 illustrent plus en détail la sous-étape d'insolation montrée à la figure 6, et la sous-étape de développement montrée à la figure 7, en considérant une unique gouttelette 30.

La figure 10 montre le flux lumineux 53 atteignant la surface de la gouttelette 30 sous forme d'un faisceau collimaté. Les rayons forment différents angles d'incidence à l'interface air/goutte, suivant le point de rencontre du rayon incident avec la surface courbée de la goutte. Ainsi plus le rayon lumineux frappe la goutte proche de son extrémité, plus l'angle d'incidence est élevé. Or la réflectance à l'interface air/goutte dépend de l'angle d'incidence.

Le graphe de la figure 11 illustre l'évolution de la réflectance (en ordonnée) en fonction de l'angle d'incidence (en abscisse) à l'interface air/eau. On constate que la réflectance augmente fortement lorsque l'angle d'incidence dépasse 60°. La quantité de lumière reçue par la couche 20 sur les bords de la gouttelette 30 est donc faible en raison de la réflectivité élevée, liée à une incidence rasante. La gouttelette 30 focalise la lumière en son centre, mais protège et masque la couche 20 sur ses bords.

Les figures 12 et 13 montrent la couche photosensible 20 après développement, sous la gouttelette 30. Le résultat est l'obtention d'une structure de géométrie tubulaire.

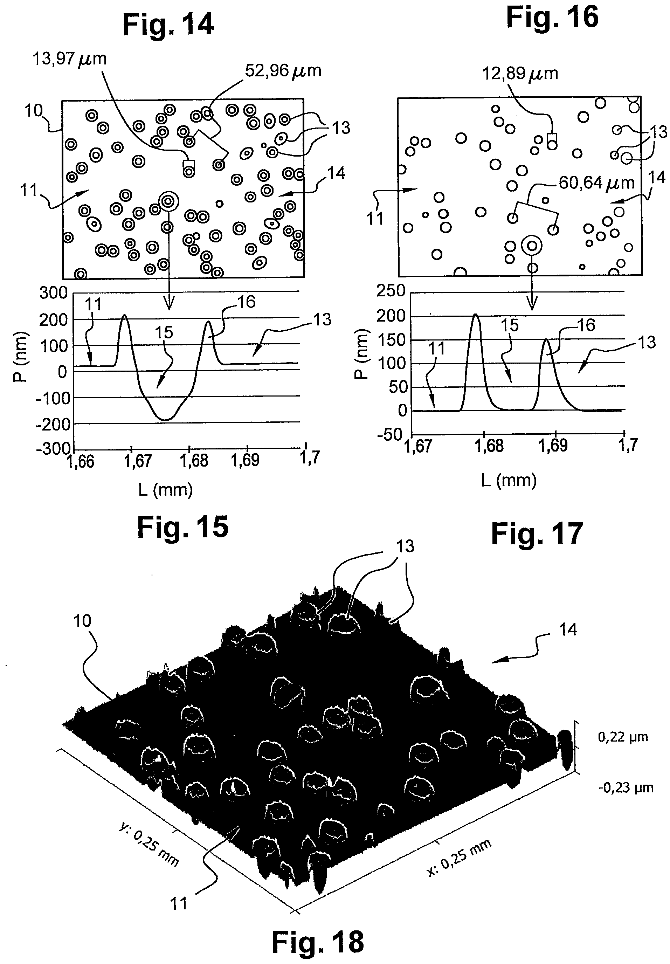

Les figures 14 à 18 montrent d'autres exemples de surfaces 11 obtenues en mettant en œuvre l'invention.

Sur les figures 14 et 15, les cavités 13 présentent une forme de cratère, avec un creux 15 plus profond que la surface 11 et des rebords 16 plus élevés que la surface 11. Comme expliqué ci-dessus en référence aux figures 10 à 13, chacune des gouttelettes 30 focalise le faisceau 53 en son centre, et masque la lumière à sa périphérie en raison d'un angle d'incidence élevé. La résine photosensible S1805 utilisée pour la couche 20 est dite positive. Le retrait des zones de la couche 20 les plus exposées à la lumière UV est donc plus important lors du développement (avec un développeur basique MF319), ce qui explique la structure obtenue pour la surface 11.

Sur les figures 16 et 17, les cavités 13 présentent une autre forme de cratère, avec un creux 15 dont le fond est situé au niveau de la surface 11, tandis que les rebords 16 sont plus élevés que la surface 11. La forme des gouttelettes 30 est différente de celle mis en œuvre dans l'exemple des figures 14 et 15 grâce à un temps de refroidissement différent. Cette forme de goutte différente permet de modifier la focalisation du faisceau 53 sur la couche 20. Ainsi, des formes de gouttelettes 30 variables induisent une insolation variable de la résine.

Sur la figure 18 est représenté un substrat 10 en perspective, ce qui permet de mieux visualiser la forme des cratères. Cette figure 18 a été obtenue en scannant la surface 11 montrée à la figure 14 à l'aide d'un profilomètre tactile.

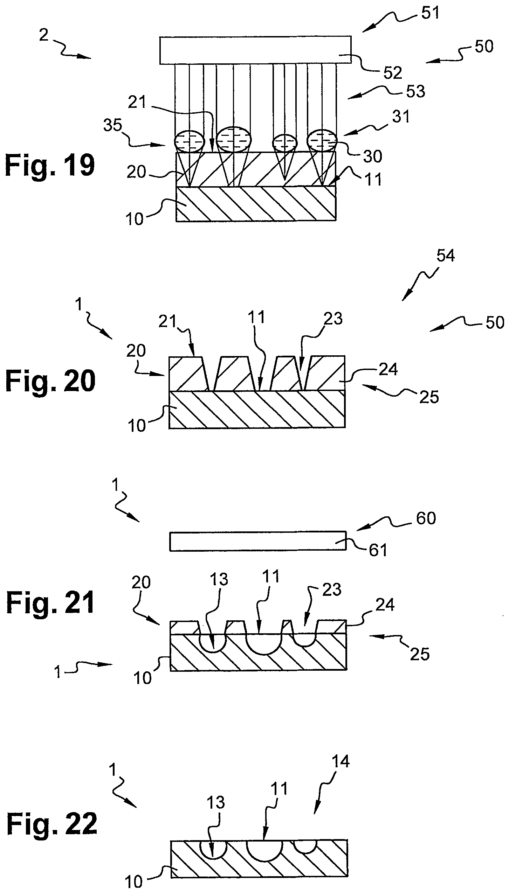

Les figures 19 à 53 montrent différentes variantes de réalisation de l'invention. Dans un but de simplification, les éléments similaires au premier mode de réalisation décrit plus haut portent les mêmes références numériques.

Dans le mode de réalisation des figures 19 à 22, la couche 20 est réalisée en résine photosensible négative, et les gouttelettes 30 remplissent une fonction d'optique de concentration du flux lumineux 53.

Sur la figure 19, lors de l'insolation par l'unité 51, les zones de la couche 20 exposées au faisceau 53 deviennent insolubles au développement, tandis que les zones de la couche 20 peu ou pas exposées restent solubles.

La figure 20 montre la couche de matière 20 après développement par l'unité 54. La couche 20 forme ainsi le masque 25, qui est agencé sur le substrat 10. Les zones de retrait 23 sont situées autour et entre les gouttelettes 30 de la figure 19, tandis que les zones 24 sont situées sous les gouttelettes 30 de la figure 19 sous forme de colonnes de matière.

La figure 21 montre la micro-texturation de la surface 11 à travers le masque 25. L'agencement des cavités 13, et donc le profil de micro-texturation 14 formé à la surface 11, dépendent de l'agencement des zones 23 et 24 de la couche 20 formant le masque 25. Après gravure, les résidus de résine de la couche 20 sont retirés du substrat 10.

La figure 22 montre le substrat 10 final, comportant les cavités 13 réparties selon le profil de micro-texturation 14. Comme l'agencement 31 des gouttelettes 30 était irrégulier, les cavités 13 présentent des formes, des dimensions et une répartition irrégulières.

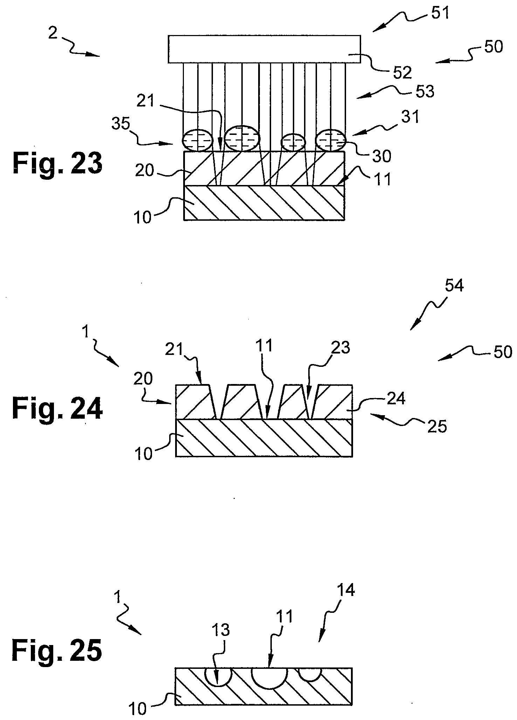

Dans le mode de réalisation des figures 23 à 25, la couche 20 est réalisée en résine photosensible positive, et les gouttelettes 30 remplissent une fonction d'optique d'occultation du flux lumineux 53. Les gouttelettes 30 sont par exemple constituées d'une solution colorée, de polymère liquide opaque ou de métal.

Sur la figure 23, lors de l'insolation par l'unité 51, les zones de la couche 20 exposées au faisceau 53 deviennent solubles au développement, tandis que les zones de la couche 20 peu ou pas exposées restent insolubles. La figure 24 montre la couche de matière 20 formant le masque 25 sur le substrat 10, après développement par l'unité 54. La figure 25 montre le substrat 10 final, comportant les cavités 13 réparties selon le profil de micro-texturation 14.

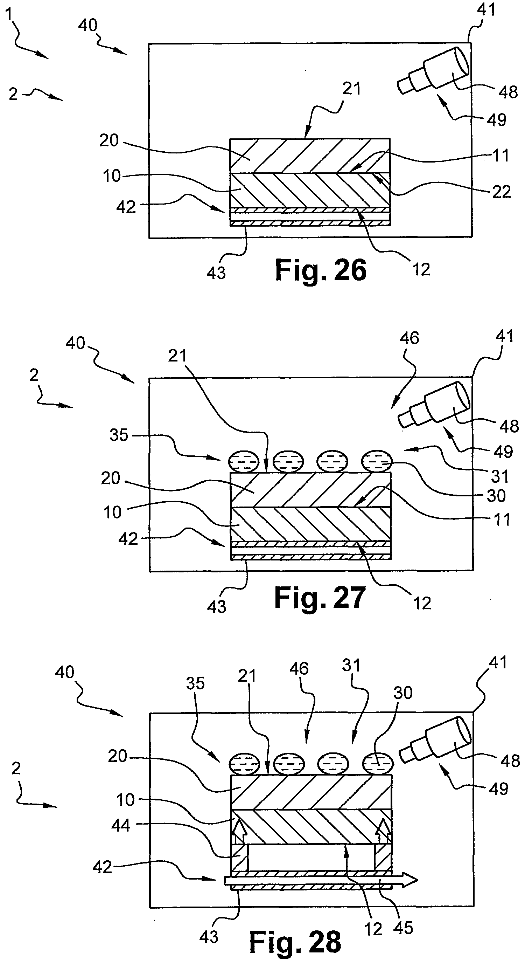

Dans le mode de réalisation des figures 26 à 32, les gouttelettes 30 se condensent sur la surface 21 selon un agencement 31 régulier et non aléatoire.

Avant introduction du substrat 10 revêtu de la couche 20 dans l'enceinte 41, la couche 20 reçoit un prétraitement de fonctionnalisation, permettant de définir des sites de fixation préférentiels des gouttelettes 30 sur la surface 21. Le prétraitement de fonctionnalisation peut être réalisé par laser, plasma, insolation ou tout autre moyen approprié. Par exemple, on réalise un balayage de la surface 21 en générant des impulsions lasers, selon un motif régulier, non aléatoire.

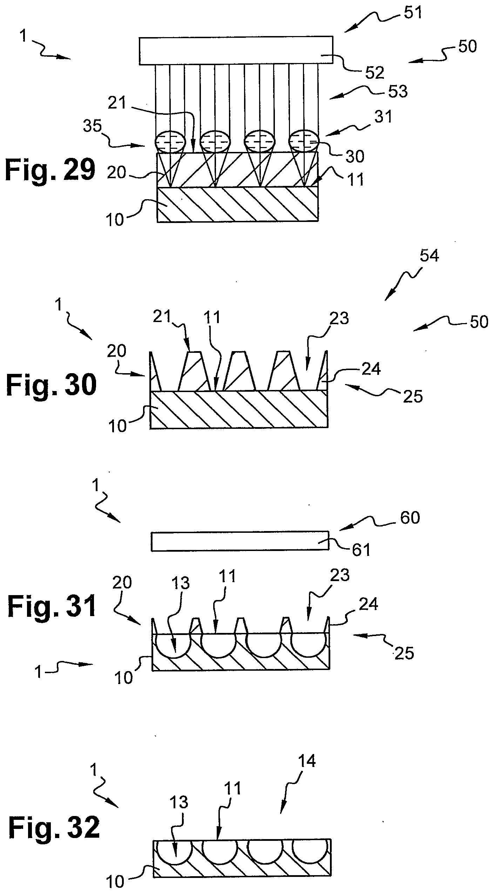

Les figures 27 à 29 montrent les gouttelettes 30 condensées sur la surface 21 selon l'agencement 31 régulier. Les figures 29 à 32 montrent successivement l'insolation de la couche 20, le développement de la couche 20, la micro-texturation du substrat 10, puis le substrat 10 final comportant les cavités 13 réparties selon le profil de micro-texturation 14. Dans ce mode de réalisation, les cavités 13 présentent des formes, des dimensions et une répartition régulières.

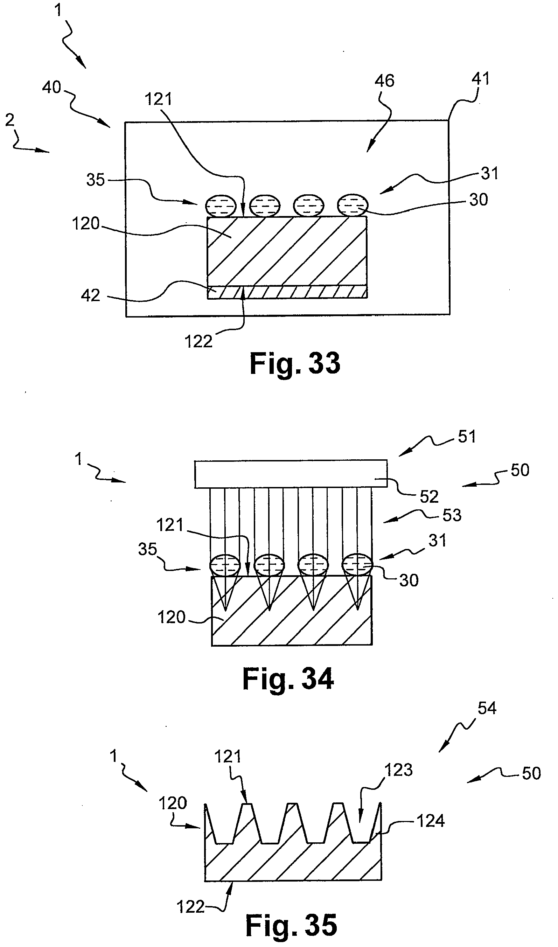

Dans le mode de réalisation des figures 33 à 35, l'installation 1 est mise en oeuvre pour texturer la surface externe 121 d'une couche de matière 120 photosensible, sans que cette couche 120 ne soit associée à un substrat 10 tel que celui du premier mode de réalisation.

La figure 33 montre la couche 120 positionnée dans un dispositif de génération et dépôt 40, prévu pour générer des gouttelettes 30 puis les déposer à la surface 121. Le dispositif 40 comprend une enceinte fermée 41 et une unité de refroidissement 42 supportant la surface 122 de la couche 120. Après dépôt et condensation, les gouttelettes 30 réparties selon l'agencement 31 forment le masque optique 35 sur la surface 121 de la couche 120.

Les figures 34 et 35 montrent un dispositif 50 de retrait localisé de la couche de matière 120, en fonction de l'agencement 31 des gouttelettes 30 sur la surface 121. Le dispositif 50 comprend une unité d'insolation 51 et une unité de développement 54. Après développement par l'unité 54, la couche 120 comporte des zones 123 de retrait de matière et des zones 124 de matière restante.

En pratique, l'étendue et la répartition des zones 123 peut être maîtrisée en agissant sur l'agencement 31 des gouttelettes 30 formant le masque optique 35, le matériau de la couche 30, les traitements appliqués à la surface 121 avant dépôt des gouttelettes 30, la durée d'insolation, etc.

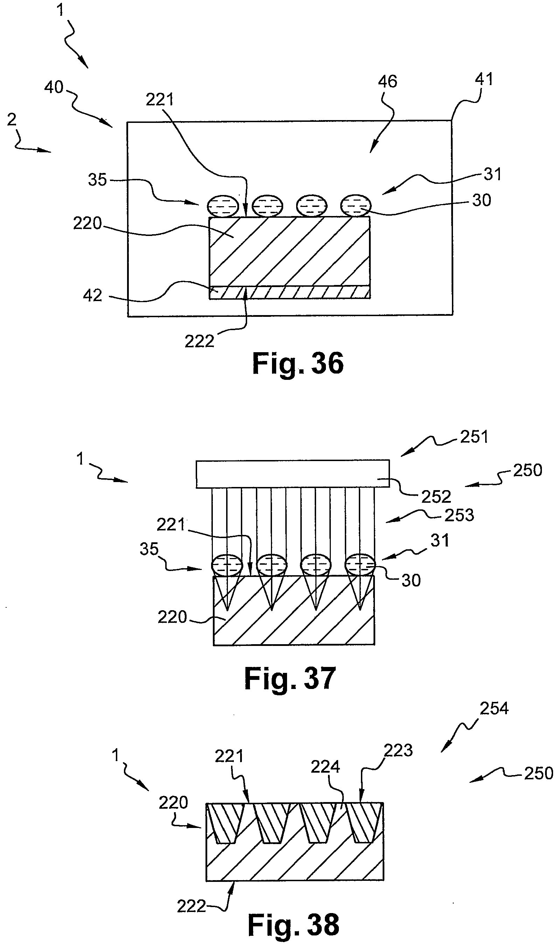

Dans le mode de réalisation des figures 36 à 38 (correspondant à une variante des figures 33 à 35) est représentée une installation 1 de traitement de surface. Cette installation 1 est conçue pour modifier les propriétés de la surface extérieure 221 d'une couche 220, sans modifier son relief.

La figure 36 montre la formation d'un masque 35 constitué de gouttelettes 30 sur la surface 221, de manière similaire à la figure 33. L'unité de refroidissement 42 supporte la surface 222 de la couche 220.

Les figures 37 et 38 montrent un dispositif 250 de traitement localisé de la couche de matière 220 dans le cas où celle-ci est photosensible, en fonction de l'agencement 31 des gouttelettes 30 sur la surface 221. Plus précisément, l'étape de traitement localisé de la couche 220 comprend une sous-étape d'insolation montrée à la figure 37, et une sous-étape de développement montrée à la figure 38. Le dispositif 50 comprend une unité d'insolation 251 et une unité de développement 254. L'unité d'insolation 251 comprend une source lumineuse 252 émettant un flux lumineux 253 qui traverse les gouttelettes 30 pour atteindre la surface 221. L'unité de développement 254 permet de modifier au moins une caractéristique de la couche de matière 220 au niveau de la surface 221, comme par exemple sa coloration, ou sa réactivité chimique. Après développement, la couche 220 comprend des zones 223 présentant un changement de caractéristique(s) localisé, par exemple un brunissement, et des zones 224 présentant les caractéristiques d'origine de la couche 220.

Dans ce mode de réalisation, le traitement est réalisé en mettant en œuvre une couche de matière 220 et un dispositif de traitement 250 différents des précédents modes de réalisation. Plus précisément, la couche 220 est une résine photoréactive différente des couches 20 et 120, tandis que le dispositif 250 comporte des éléments constitutifs différents du dispositif 50, afin de traiter la couche 220, et notamment la surface 221, sans modifier son relief. En alternative, l'installation 1 peut comporter une couche 220 traitée par le dispositif 50, ou bien une couche 20 ou 120 traitée par le dispositif 250.

D'autres installations 1 de traitement de surface peuvent être mises en œuvre sans sortir du cadre de l'invention, afin de modifier différentes propriétés de la surface traitée, sans nécessairement modifier son relief.

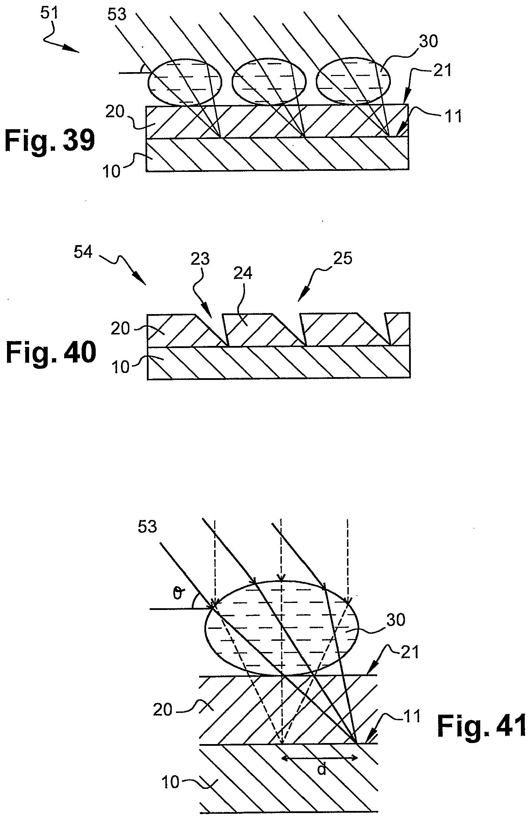

Dans le mode de réalisation des figures 39 à 41, le faisceau lumineux 53 est dirigé sur les gouttelettes 30 selon un angle d'incidence oblique, par rapport à une direction normale à la surface 21 de la couche 20. Dans ces conditions, le motif formant le masque 25 est également oblique.

Comme montré à la figure 41, ce motif est translaté d'une distance « d » par rapport au centre de la gouttelette 30, en fonction de l'angle d'incidence du faisceau lumineux 53.

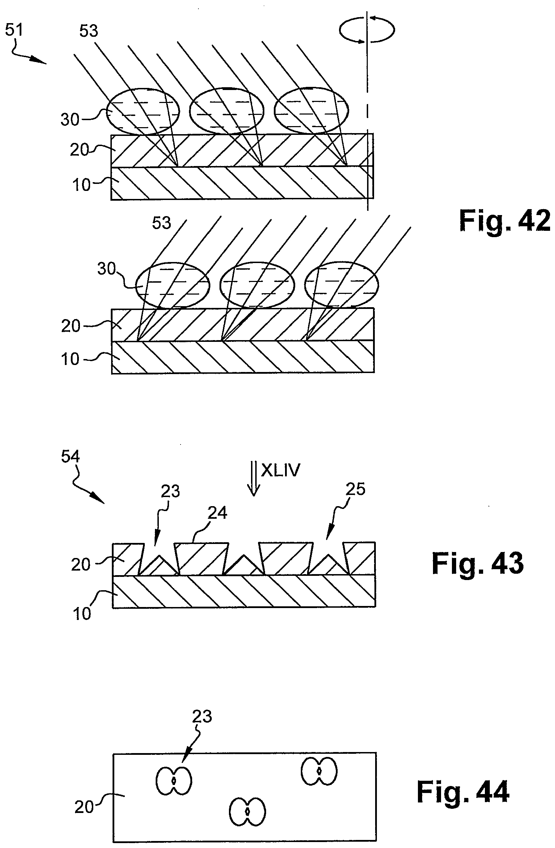

Dans le mode de réalisation des figures 42 à 44, la couche 20 est soumise à une exposition multiple, sous un faisceau 53 présentant un angle d'incidence oblique, associé à une rotation du substrat 10.

Comme montré à la figure 42, la couche 20 est exposée à un faisceau 53 présentant un angle d'incidence oblique, puis le substrat 10 pivote à 180° autour d'un axe normal à la surface 21, puis la couche 20 est de nouveau exposée à un faisceau 53 présentant un angle d'incidence oblique.

Comme montré aux figures 43 et 44, lors d'une exposition sous un angle d'incidence différent de la normale, il est possible d'obtenir des géométries de motif autres que cylindrique, en raison de la translation du motif inscrit par rapport au centre de la gouttelette 30.

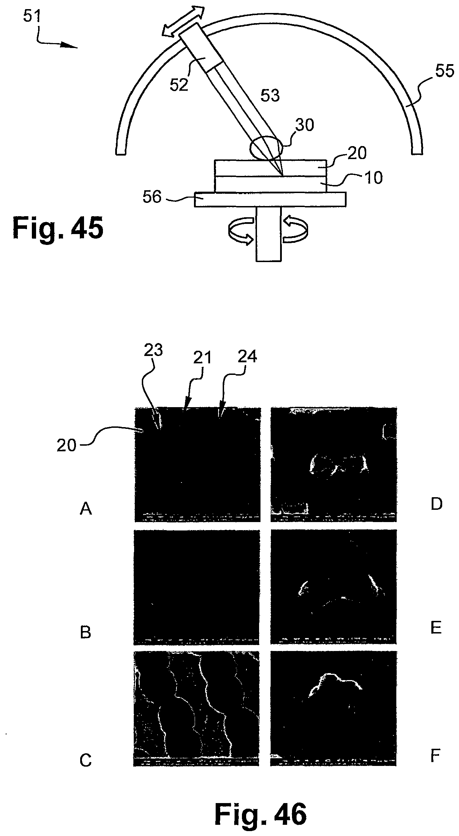

La figure 45 montre un exemple d'unité d'insolation 51 conçue pour exposer les gouttelettes 30 et la couche 20 à un faisceau lumineux 53 oblique.

L'unité 51 comprend un rail hémisphérique 55, sur lequel est montée une source lumineuse 52, par exemple une source de lumière UV collimatée. Déplacer la source 52 le long du rail 55 permet de modifier l'angle d'incidence du faisceau 53 utilisé pour insoler la couche photosensible 20.

L'unité 51 comprend également une platine 56 mobile en rotation, recevant le substrat 10. La platine 56 permet de tourner le substrat 10 et la couche 20 entre chaque opération d'insolation de la couche photosensible 20.

La figure 46 montre différents exemples de couches 20 de résine après insolation sous faisceau oblique, puis développement.

Sur la gauche, les exemples A, B et C sont obtenus avec une résine photosensible positive, tandis que sur la droite, les exemples D, E et F sont obtenus avec une résine photosensible négative.

Les exemples A, C, D et E montrent chacun une couche 20 soumise à deux insolations successives sous incidence oblique, avec une rotation de 180° entre chaque exposition, permettant d'obtenir un motif en "nœud papillon".

Les exemples B et F montrent chacun une couche 20 soumise à quatre insolations successives sous incidence oblique, avec une rotation de 90° entre chaque exposition, permettant d'obtenir un motif en "trèfle à quatre feuilles'.

De tels motifs trouvent des applications par exemple en analyse chimique (concentration de champ, effet plasmonique) et en microbiologie.

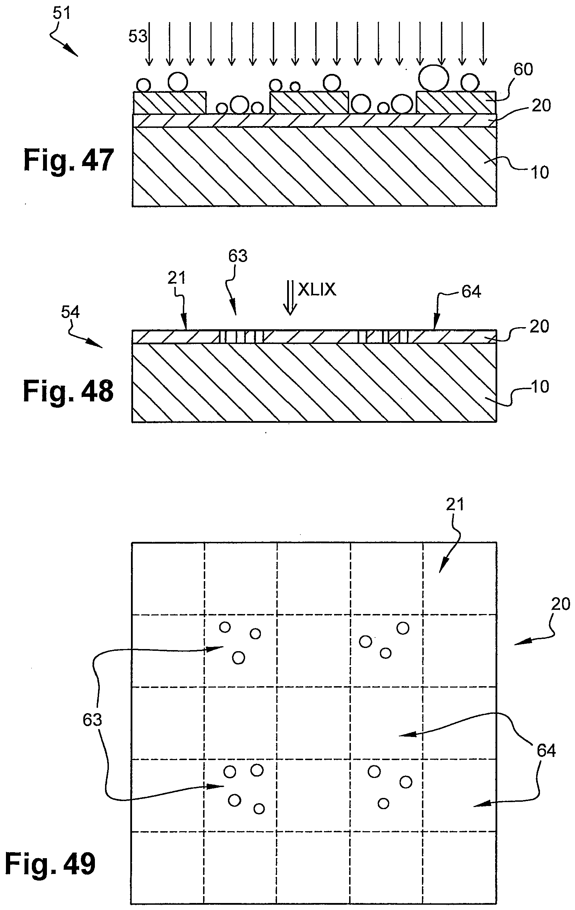

Dans le mode de réalisation des figures 47 à 49, la condensation des gouttelettes 30 s'effectue sur une couche 20 comportant un masque sacrificiel 60 en forme de grille.

Après insolation et développement, la couche 20 comporte une microstructuration selon un arrangement prédéfini imposé par ce masque 60. La couche 20 comporte des zones 63 comportant des évidements et des zones 64 de matière intacte.

Comme montré à la figure 49, le masque 60 impose un arrangement périodique. Après insolation de la couche 20 et enlèvement du masque 60, la microstructuration réalisée sur la surface 21 n'est pas répartie de manière homogène, mais selon cette périodicité imposée (dans une ou plusieurs directions, en fonction de la construction du masque 60).

A ce stade, la couche 20 peut de nouveau recevoir des gouttelettes 30 condensées. Les zones 63 constituent alors des sites de fixation préférentiels des gouttelettes 30 sur la surface 21. Autrement dit, le masque 60 permet de réaliser un prétraitement de fonctionnalisation de la couche 20.

En alternative, le prétraitement de fonctionnalisation peut être réalisé par laser, plasma, insolation ou tout autre moyen approprié, afin de définir des sites de fixation préférentiels des gouttelettes 30 sur la surface 21.

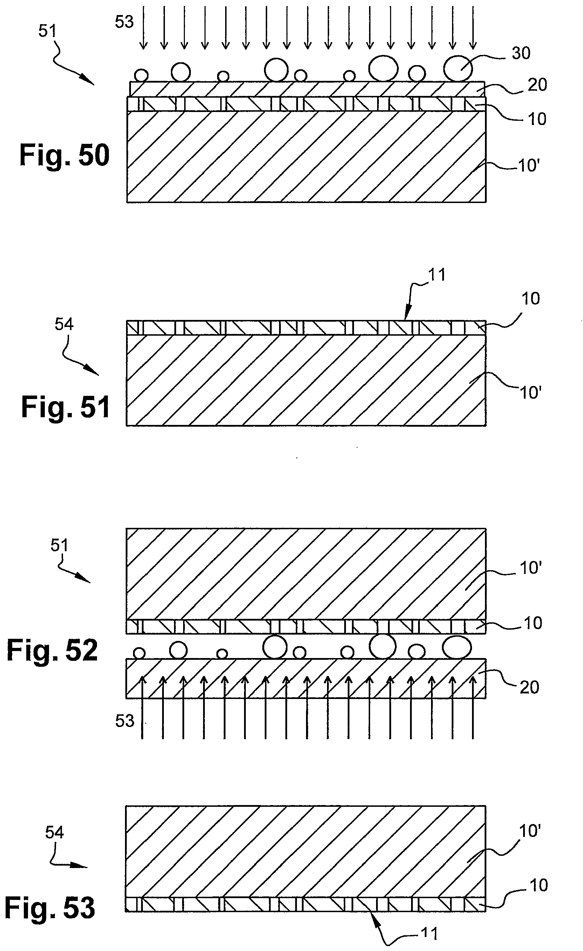

Dans le mode de réalisation des figures 50 et 51, la condensation des gouttelettes 30 est réalisée sur une couche 20 perméable au flux lumineux 53. La couche 20 peut être transparente ou translucide, par exemple en verre ou en matière plastique.

Les gouttelettes 30 déposées sur la couche 20 forment un masque optique 35 pour l'insolation du substrat 10, lui-même positionné sur un support 10'. Le substrat 10 est par exemple en résine photosensible.

Cette approche, par rapport aux précédentes, se différencie par le fait que le masque 35 peut être utilisé plusieurs fois sur le même substrat 10, par déplacement de la couche 20 et/ou du substrat 10 lors de l'insolation. Elle permet de reproduire régulièrement un motif défini par le masque optique 35 sur la surface 11 du substrat 10.

Le mode de réalisation des figures 52 et 53 est une variante de celui des figures 50 et 51. La couche 20 comportant les gouttelettes 30 formant le masque 35 est disposée sous le substrat 10. Cette fois encore, le masque 35 peut être utilisé plusieurs fois sur le même substrat 10, en déplaçant la couche 20 et/ou du substrat 10 lors de l'insolation. Cela permet de reproduire régulièrement un motif défini par le masque optique 35 sur la surface 11 du substrat 10.

Les caractéristiques techniques des différents modes de réalisation et variantes mentionnés dans la présente description peuvent être, en totalité ou pour certaines d'entre elles, combinées entre elles. Ainsi, l'installation 1 et le système 2 peuvent être adaptés en termes de coût, de fonctionnalités et de performances.

## Revendications

1. Système (2) de réalisation d'un masque optique (35) pour traitement de surface, notamment pour micro-texturation de surface, le système (2) comprenant :
- une couche de matière (20 ; 120 ; 220) comportant une surface externe (21 ; 121 ; 221) exposée à l'environnement extérieur ; et
- un dispositif de génération et dépôt (40) de gouttelettes (30) sur la surface externe (21 ; 121 ; 221) de la couche de matière (20 ; 120; 220), selon un agencement (31) particulier, formant le masque optique (35) sur la surface externe (21 ; 121 ; 221) de la couche de matière (20 ; 120 ; 220).
**caractérisé en ce que** la surface externe (21 ; 121 ; 221) de la couche de matière (20 ; 120 ; 221) est initialement traitée pour définir des sites de fixation préférentiels des gouttelettes (30), permettant ainsi de maîtriser l'agencement (31) des gouttelettes (30) formant le masque optique (35) sur la surface externe (21 ; 121 ; 221).

2. Système (2) selon la revendication 1, **caractérisé en ce qu'**il comprend un substrat (10) comportant une surface (11) recouverte par la couche de matière (20).

3. Système (2) selon la revendication 1, **caractérisé en ce que** la couche de matière (20) est perméable au flux lumineux, et **en ce que** le système (2) comprend un substrat (10) comportant une surface (11) disposée en regard de la couche de matière (20).

4. Installation (1) de traitement de surface, comprenant :
- un système (2) de réalisation d'un masque optique (35) selon l'une des revendications 1 à 3 ; et
- un dispositif de traitement localisé (50 ; 250) de la couche de matière (20 ; 120 ; 220), en fonction de l'agencement (31) des gouttelettes (30) formant le masque optique (35) sur la surface externe (21 ; 121 ; 221), à travers le masque optique (35) formé sur la couche de matière (20 ; 120 ; 220).

5. Installation (1) selon la revendication 4, **caractérisée en ce que** le dispositif de traitement localisé (50) de la couche de matière (20 ; 120) constitue un dispositif de retrait localisé de la couche de matière (20 ; 120), en fonction de l'agencement (31) des gouttelettes (30) formant le masque optique (35) sur la surface externe (21 ; 121) de la couche de matière (20 ; 120), laquelle comporte alors des zones de retrait (23 ; 123) et des zones de matière (24 ; 124).

6. Installation (1) de traitement de surface, comprenant :
- un système (2) de réalisation d'un masque optique (35) selon la revendication 2;
- un dispositif de retrait localisé (50) de la couche de matière (20), en fonction de l'agencement (31) des gouttelettes (30) formant le masque optique (35) sur la surface externe (21), à travers le masque optique (35) formé sur la couche de matière (20), laquelle comporte alors des zones de retrait (23) et des zones de matière (24) formant un second masque (25) sur le substrat (10) ; et
- un dispositif de traitement localisé (60) de la surface (11) du substrat (10) à travers le second masque (25) formé par la couche de matière (20) sur le substrat (10).

7. Installation (1) selon la revendication 5, **caractérisée en ce que** le dispositif de traitement localisé (60) de la surface (11) du substrat (10) est un dispositif de micro-texturation, comprenant par exemple une unité de gravure ionique réactive, une unité de gravure chimique ou une unité de gravure optique.

8. Installation (1) selon l'une des revendications 4 à 7, **caractérisée en ce que** la couche de matière (20 ; 120 ; 120) est réalisée en matériau photosensible, et **en ce que** le dispositif de traitement localisé (50 ; 250) de la couche de matière (20 ; 120 ; 220) comprend, d'une part, une unité d'insolation (51 ; 251) émettant un flux lumineux (53 ; 253) qui traverse les gouttelettes (30) et atteint la surface externe (21 ; 121 ; 221) de la couche de matière (20 ; 120 ; 220) et, d'autre part, une unité de développement (54; 254) de la couche de matière (20; 120 ; 220) après exposition au flux lumineux (53 ; 253).

9. Installation (1) de traitement de surface, comprenant :
- un système (2) de réalisation d'un masque optique (35) selon la revendication 3 ;
- un dispositif de traitement localisé (50 ; 250) du substrat (10), en fonction de l'agencement (31) des gouttelettes (30) formant le masque optique (35) sur la surface externe (21 ; 121 ; 221) de la couche de matière (20 ; 120 ; 220), à travers le masque optique (35) formé sur la couche de matière (20 ; 120 ; 220) perméable au flux lumineux.

10. Installation (1) selon l'une des revendications 6 à 9, **caractérisée en ce que** le substrat (10) est réalisé en matériau photosensible, et **en ce que** le dispositif de traitement localisé (50 ; 250) du substrat (10) comprend, d'une part, une unité d'insolation (51 ; 251) émettant un flux lumineux (53 ; 253) qui traverse les gouttelettes (30) et atteint la surface (11) du substrat (10) et, d'autre part, une unité de développement (54 ; 254) du substrat (10) après exposition au flux lumineux (53 ; 253).

11. Méthode de réalisation d'un masque optique (35) pour traitement de surface, notamment pour micro-texturation de surface, la méthode comprenant les étapes suivantes :
- une étape de fourniture d'une couche de matière (20 ; 120 ; 220) comportant une surface externe (21 ; 121 ; 221) exposée à l'environnement extérieur ;
- une étape de prétraitement de la couche de matière (20 ; 120 ; 221), le prétraitement définissant des sites de fixation préférentiels (63) de gouttelettes (30) à la surface externe (21 ; 121 ; 221) de la couche de matière (20 ; 120 ; 221), permettant ainsi de maîtriser l'agencement (31) des gouttelettes (30) formant le masque optique (35) sur la surface externe (21 ; 121 ; 221) ; et
- une étape de génération et dépôt de gouttelettes (30) sur la surface externe (21 ; 121 ; 221) de la couche de matière (20; 120; 220), selon un agencement (31) particulier, formant ainsi le masque optique (35) sur la surface externe (21 ; 121 ; 221) de la couche de matière (20 ; 120 ; 220).

12. Méthode de traitement de surface comprenant les étapes successives suivantes :
a) une étape de fourniture d'une couche de matière (20 ; 120 ; 220) comportant une surface externe (21 ; 121 ; 221) exposée à l'environnement extérieur ;
b) une étape de prétraitement de la couche de matière (20 ; 120 ; 221), le prétraitement définissant des sites de fixation préférentiels (63) de gouttelettes (30) à la surface externe (21 ; 121 ; 221) de la couche de matière (20 ; 120 ; 221), permettant ainsi de maîtriser l'agencement (31) des gouttelettes (30) formant un masque optique (35) sur la surface externe (21 ; 121 ; 221) ;
c) une étape de génération et dépôt de gouttelettes (30) sur la surface externe (21 ; 121 ; 221) de la couche de matière (20; 120 ; 220), selon un agencement (31) particulier, formant ainsi le masque optique (35) sur la surface externe (21 ; 121 ; 221) de la couche de matière (20 ; 120 ; 220) ; et
d) une étape de traitement localisé de la couche de matière (20 ; 120 ; 220) en fonction de l'agencement (31) des gouttelettes (30) sur la surface externe (21 ; 121 ; 221), à travers le masque optique (35) formé sur la couche de matière (20 ; 120 ; 220).

13. Méthode de traitement de surface comprenant les étapes successives suivantes :
a) une étape de fourniture d'un substrat (10) ayant une surface (11) recouverte par une couche de matière (20), qui comporte une surface externe (21) exposée à l'environnement extérieur ;
b) une étape de prétraitement de la couche de matière (20), le prétraitement définissant des sites de fixation préférentiels (63) de gouttelettes (30) à la surface externe (21) de la couche de matière (20), permettant ainsi de maîtriser l'agencement (31) des gouttelettes (30) formant un masque optique (35) sur la surface externe (21) ;
c) une étape de génération et dépôt de gouttelettes (30) sur la surface externe (21) de la couche de matière (20), selon un agencement (31) particulier, formant ainsi le masque optique (35) sur la surface externe (21) de la couche de matière (20) ;
d) une étape de retrait localisé de la couche de matière (20) en fonction de l'agencement (31) des gouttelettes (30) sur la surface externe (21), à travers le masque optique (35) formé sur la couche de matière (20), laquelle comporte alors des zones de retrait (23) et des zones de matière (24) formant un second masque (25) sur le substrat (10) ; et
e) une étape de traitement localisé de la surface (11) du substrat (10) à travers le second masque (25) formé par la couche de matière (20) sur le substrat (10).

14. Méthode de traitement de surface comprenant les étapes successives suivantes :
a) une étape de fourniture d'une couche de matière (20 ; 120 ; 220) perméable au rayonnement lumineux et comportant une surface externe (21 ; 121 ; 221) exposée à l'environnement extérieur ;
b) une étape de prétraitement de la couche de matière (20 ; 120 ; 221), le prétraitement définissant des sites de fixation préférentiels (63) de gouttelettes (30) à la surface externe (21 ; 121 ; 221) de la couche de matière (20 ; 120 ; 221), permettant ainsi de maîtriser l'agencement (31) des gouttelettes (30) formant un masque optique (35) sur la surface externe (21 ; 121 ; 221) ;
c) une étape de fourniture d'un substrat (10) ayant une surface (11) disposée en regard de la couche de matière (20) ;
d) une étape de génération et dépôt de gouttelettes (30) sur la surface externe (21) de la couche de matière (20), selon un agencement (31) particulier, formant ainsi le masque optique (35) sur la surface externe (21) de la couche de matière (20) ;
e) une étape de traitement localisé de la surface (11) du substrat (10) à travers le masque optique (35) formé par les gouttelettes (30) sur la couche de matière (20).

15. Méthode selon la revendication 14, **caractérisée en ce qu'**au cours de l'étape de traitement e), un déplacement relatif peut être effectué entre la surface (11) du substrat (10) et la couche de matière (20 ; 120 ; 220) supportant les gouttelettes (30) qui forment le masque optique (35), de manière à reproduire régulièrement sur la surface (11) du substrat (10) un motif défini par le masque optique (35).

16. Méthode selon l'une des revendications 12 à 15, **caractérisée en ce que** l'étape de génération et dépôt de gouttelettes (30) est répétée plusieurs fois pour modifier l'agencement (31) des gouttelettes (30) formant le masque optique (35), avant la réalisation de l'étape suivante.

## Patentansprüche

1. System (2) zur Herstellung einer optischen Maske (35) zur Oberflächenbehandlung, insbesondere zur Oberflächen- Mikrotexturierung, wobei das System (2) umfasst:
- eine Materialschicht (20; 120; 220) mit einer der äußeren Umgebung zugewandten Außenfläche (21; 121; 221); und
- eine Vorrichtung zur Erzeugung und Ablagerung (40) von Tröpfchen (30) auf der Außenfläche (21; 121; 221) der Materialschicht (20; 120; 220), entsprechend einer besonderen Anordnung (31), die eine optische Maske (35) auf der Außenfläche (21; 121; 221) der Materialschicht (20; 120; 220) bildet;
**dadurch gekennzeichnet, dass** die Außenfläche (21; 121; 221) der Materialschicht (20; 120; 220) am Anfang so behandelt wird, dass bevorzugte Fixierungsorte der Tröpfchen (30) definiert werden, wodurch es möglich wird, die Anordnung (31) der Tröpfchen (30), die die optische Maske (35) auf der Außenfläche (21; 121; 221) bilden, zu beherrschen.

2. System (2) gemäß Anspruch 1, **dadurch gekennzeichnet, dass** es ein Substrat (10) mit einer Fläche (11), enthält, die von der Materialschicht (20) bedeckt wird.

3. System (2) gemäß Anspruch 1, **dadurch gekennzeichnet, dass** die Materialschicht (20) gegenüber dem Lichtstrom durchlässig ist und dass das System (2) ein Substrat (10) mit einer gegenüber der Materialschicht (20) angeordneten Fläche (11) enthält.

4. Anlage (1) zur Oberflächenbehandlung, die umfasst:
- ein System (2) zur Herstellung einer optischen Maske (35) nach einem der Ansprüche 1 bis 3; und
- eine Vorrichtung zur lokal begrenzten Bearbeitung (50; 250) der Materialschicht (20; 120; 220) entsprechend der Anordnung (31) der Tröpfchen (30), die die optische Maske (35) , auf der Außenfläche (21; 121; 221) bilden, durch die optische Maske (35) hindurch, die auf der Materialschicht (20; 120; 220) gebildet wurde.

5. Anlage (1) gemäß Anspruch 4, **dadurch gekennzeichnet, dass** die Vorrichtung zur lokal begrenzten Bearbeitung (50) der Materialschicht (20; 120) eine Vorrichtung zur lokal begrenzten Abtragung der Materialschicht (20; 120) darstellt, entsprechend der Anordnung (31) der Tröpfchen (30), die die optische Maske (35), auf der Außenfläche (21; 121) der Materialschicht (20; 120) bilden, die dann Abtragungszonen (23; 123) und Materialzonen (24; 124) enthält.

6. Anlage (1) zur Oberflächenbehandlung, die umfasst:
- ein System (2) zur Herstellung einer optischen Maske (35) nach Anspruch 2
- eine Vorrichtung zur lokal begrenzten Abtragung (50) der Materialschicht (20), in Abhängigkeit von der Anordnung (31) der Tröpfchen (30), die die optische Maske (35) auf der Außenfläche (21) der Materialschicht (20) bilden, durch die optische Maske (35) hindurch, die auf der Materialschicht (20) gebildet wurde, die dann Abtragungszonen (23) und Materialzonen (24) enthält, die eine zweite Maske (25) auf dem Substrat (10) bilden; und
- eine Vorrichtung zur lokal begrenzten Bearbeitung (60) der Oberfläche (11) des Substrats (10) durch die zweite Maske (25) hindurch, die von der Materialschicht (20) auf dem Substrat (10) gebildet wird.

7. Anlage (1) nach Anspruch 5, **dadurch gekennzeichnet, dass** es sich bei der Vorrichtung zur lokal begrenzten Bearbeitung (60) der Oberfläche (11) des Substrats (10) um eine Mikrotexturierungs- Vorrichtung handelt, die zum Beispiel eine Plasmaätzeinheit, eine chemische Ätzeinheit oder eine optische Ätzeinheit enthält.

8. Anlage (1) nach einem der Ansprüche 4 bis 7, **dadurch gekennzeichnet, dass** die Materialschicht (20; 120; 220) aus fotosensiblen Material besteht, und dass die Vorrichtung zur lokal begrenzten Bearbeitung (50; 250) der Materialschicht (20; 120; 220) erstens eine Belichtereinheit (51; 251) enthält, die einen Lichtstrom (53; 253) aussendet, der die Tröpfchen (30) durchquert und auf die Außenfläche (21; 121; 221) der Materialschicht (20; 120; 220) gelangt und zweitens eine Entwicklereinheit (54; 254) für die Materialschicht (20; 120; 220), nach der Exposition gegenüber dem Lichtstrom (53; 253).

9. Anlage (1) zur Oberflächenbehandlung, die umfasst:
- ein System (2) zur Herstellung einer optischen Maske (35) nach Anspruch 3;
- Vorrichtung zur lokal begrenzten Bearbeitung (50; 250) des Substrats (10) entsprechend der Anordnung (31) der Tröpfchen (30), die die optische Maske (35), auf der Außenfläche (21; 121; 221) der Materialschicht (20; 120; 220) bilden, durch die optische Maske (35) hindurch, die auf der Materialschicht (20; 120; 220) gebildet wurde und gegenüber dem Lichtstrom durchlässig ist.

10. Anlage (1) nach einem der Ansprüche 6 bis 9, **dadurch gekennzeichnet, dass** das Substrat (10) aus fotosensiblen Material besteht, und dass die Vorrichtung zur lokal begrenzten Bearbeitung (50; 250) des Substrats (10) erstens eine Belichtereinheit (51; 251) enthält, die einen Lichtstrom (53; 253) aussendet, der die Tröpfchen (30) durchquert und auf die Oberfläche (11) des Substrats (10) gelangt und zweitens eine Entwicklereinheit (54; 254) für das Substrat (10) nach der Exposition gegenüber dem Lichtstrom (53; 253).

11. Herstellungsverfahren einer optischen Maske (35) zur Oberflächenbehandlung, insbesondere zur Oberflächen- Mikrotexturierung, wobei das Verfahren die folgenden Schritte umfasst:
- einen Schritt der Bereitstellung einer Materialschicht (20; 120; 220) mit einer der äußeren Umgebung zugewandte Außenfläche (21; 121; 221);
- einen Schritt der Vorbehandlung der Materialschicht (20; 120; 220), die Vorbehandlung definiert bevorzugte Fixierungsorte (63) der Tröpfchen (30) auf der Außenfläche (21; 121; 221) der Materialschicht (20; 120; 220); wodurch es möglich wird, die Anordnung (31) der Tröpfchen (30), die die optische Maske (35) auf der Außenfläche (21; 121; 221) bilden, zu beherrschen; und
- einen Schritt der Erzeugung und Ablagerung von Tröpfchen (30) auf der Außenfläche (21; 121; 221) der Materialschicht (20; 120; 220), entsprechend einer besonderen Anordnung (31), wodurch die optische Maske (35) auf der Außenfläche (21; 121; 221) der Materialschicht (20; 120; 220) gebildet wird.

12. Verfahren zur Oberflächenbehandlung, das die folgenden aufeinanderfolgenden Schritte umfasst:
a) einen Schritt der Bereitstellung einer Materialschicht (20; 120; 220) mit einer der äußeren Umgebung zugewandte Außenfläche (21; 121; 221);
b) einen Schritt der Vorbehandlung der Materialschicht (20; 120; 220), die Vorbehandlung definiert dabei bevorzugte Fixierungsorte (63) der Tröpfchen (30) auf der Außenfläche (21; 121; 221) der Materialschicht (20; 120; 220); wodurch es möglich wird, die Anordnung (31) der Tröpfchen (30), die eine optische Maske (2) auf der Außenfläche (21; 121; 221) bilden, zu beherrschen;
c) einen Schritt der Erzeugung und Ablagerung von Tröpfchen (30) auf der Außenfläche (21; 121; 221) der Materialschicht (20; 120; 220), entsprechend einer besonderen Anordnung (31), die so die optische Maske (35) auf der Außenfläche (21; 121; 221) der Materialschicht (20; 120; 220) bildet; und
d) einen Schritt der lokal begrenzten Bearbeitung der Materialschicht (20; 120; 220) entsprechend der Anordnung (31) der Tröpfchen (30), auf der Außenfläche (21; 121; 221), durch die optische Maske (35) hindurch, die auf der Materialschicht (20; 120; 220) gebildet wurde.

13. Verfahren zur Oberflächenbehandlung, das die folgenden aufeinanderfolgenden Schritte umfasst:
a) einen Schritt der Bereitstellung eines Substrats (10) mit einer Oberfläche (11), die von einer Materialschicht (20) bedeckt wird, die eine der äußeren Umgebung zugewandte Außenfläche (21) enthält;
b) einen Schritt der Vorbehandlung der Materialschicht (20), die Vorbehandlung definiert dabei bevorzugte Fixierungsorte (63) der Tröpfchen (30) auf der Außenfläche (21) der Materialschicht (20); wodurch es möglich wird, die Anordnung (31) der Tröpfchen (30), die eine optische Maske (35) auf der Außenfläche (21) bilden, zu beherrschen;
c) einen Schritt der Erzeugung und Ablagerung von Tröpfchen (30) auf der Außenfläche (21) der Materialschicht (20), durch eine besondere Anordnung (31), die so die optische Maske (35) auf der Außenfläche (21) der Materialschicht (20) bildet;
d) einen Schritt der lokal begrenzten Abtragung der Materialschicht (20), in Abhängigkeit von der Anordnung (31) der Tröpfchen (30) auf der Außenfläche (21), durch die optische Maske (35) hindurch, die auf der Materialschicht (20) gebildet wird, die dann Abtragungszonen (23) und Materialzonen (24) enthält, die eine zweite Maske (25) auf dem Substrat (10) bilden; und
e) einen Schritt der lokal begrenzten Bearbeitung der Oberfläche (11) des Substrats (10) durch die zweite Maske (25) hindurch, die von der Materialschicht (20) auf dem Substrat (10) gebildet wird.

14. Verfahren zur Oberflächenbehandlung, das die folgenden aufeinanderfolgenden Schritte umfasst:
a) einen Schritt der Bereitstellung einer Materialschicht (20; 120; 220), die gegenüber der Lichtstrahlung durchlässig ist und eine der äußeren Umgebung zugewandte Außenfläche (21; 121; 221) umfasst;
b) einen Schritt der Vorbehandlung der Materialschicht (20; 120; 220), wobei die Vorbehandlung bevorzugte Fixierungsorte (63) der Tröpfchen (30) auf der Außenfläche (21; 121; 221) der Materialschicht (20; 120; 220) definiert; wodurch es möglich wird, die Anordnung (31) der Tröpfchen (30), die die die optische Maske (35) auf der Außenfläche (21; 121; 221) bilden, zu beherrschen;
c) einen Schritt der Bereitstellung eines Substrats (10) mit einer Fläche (11), die gegenüber der Materialschicht (20) angeordnet ist;
d) einen Schritt der Erzeugung und Ablagerung von Tröpfchen (30) auf der Außenfläche (21) der Materialschicht (20), durch eine besondere Anordnung (31) die so die optische Maske (35) auf der Außenfläche (21) der Materialschicht (20) bildet;
e) einen Schritt der lokal begrenzten Bearbeitung der Oberfläche (11) des Substrats (10) durch die zweite Maske (35) hindurch, die von den Tröpfchen (30) auf der Materialschicht (20) gebildet wird.

15. Verfahren nach Anspruch 14, **dadurch gekennzeichnet, dass** während des Bearbeitungsschritt e) eine relative Verschiebung zwischen der Oberfläche (11) des Substrats (10) und der Materialschicht (20; 120; 220), die die Tröpfchen (30) trägt, die die optische Maske (35) bilden, stattfinden kann, um auf der Oberfläche (11) des Substrats (10) ein von der optischen Maske (35) definiertes Motiv regelmäßig zu reproduzieren.

16. Verfahren nach einem der Ansprüche 12 bis 15, **dadurch gekennzeichnet, dass** der Schritt der Erzeugung und Ablagerung von Tröpfchen (30) mehrmals wiederholt wird, um die Anordnung (31) der Tröpfchen (30), die die optische Maske (35) bilden, vor Ausführung des nächsten Schritts zu ändern.

## Claims

1. A system (2) for producing an optical mask (35) for surface treatment, in particular for surface microtexturing, the system (2) comprising:
- a layer of material (20; 120; 220) which has an outer surface (21; 121; 221) that is exposed to the outside environment; and
- a generating and depositing device (40) of droplets (30) on the outer surface (21; 121; 221) of the layer of material (20; 120; 220), in a specific arrangement (31), forming the optical mask (35) on the outer surface (21; 121; 221) of the layer of material (20; 120; 220).
**characterized in that** the outer surface (21; 121; 221) of the layer of material (20; 120; 220) is initially treated to define preferential fixing sites of the droplets (30), thus enabling the arrangement (31) of the droplets (30) forming the optical mask (35) on the outer surface (21; 121; 221)

2. System (2) according to claim 1, **characterized in that** it comprises a substrate (10) having a surface (11) covered by the layer of material (20).

3. System (2) according to claim 1, **characterized in that** the layer of material (20) is permeable to the luminous flux, and **in that** the system (2) comprises a substrate (10) having a surface (11) arranged opposite the layer of material (20).

4. A surface treatment plant (1), comprising:
- a system (2) for producing an optical mask (35) according to one of claims 1 to 3; and
- a localized treatment device (50; 250) of the layer of material (20; 120; 220), depending on the arrangement (31) of the droplets (30) forming the optical mask (35) on the outer surface (21; 121; 221), through the optical mask (35) formed on the layer of material (20; 120; 220).

5. Plant (1) according to claim 4, **characterized in that** the localized treatment device (50) of the layer of material (20; 120) constitutes a localized removal device of the layer of material (20; 120), depending on the arrangement (31) of the droplets (30) forming the optical mask (35) on the outer surface (21; 121) of the layer of material (20; 120), which thus comprises removal areas (23; 123) and material areas (24; 124).

6. Surface treatment plant (1), comprising:
- a system (2) for producing an optical mask (35) according to claim 2;
- a localized treatment device (50) of the layer of material (20), depending on the arrangement (31) of the droplets (30) forming the optical mask (35) on the outer surface (21), through the optical mask (35) formed on the layer of material (20), which thus has removal areas (23) and material areas (24) forming a second mask (25) on the substrate (10); and
- a localized treatment device (60) of the surface (11) of the substrate (10) through the second mask (25) formed by the layer of material (20) on the substrate (10).

7. Plant (1) according to claim 5, **characterized in that** the localized treatment device (60) of the surface (11) of the substrate (10) is a microtexturing device, comprising for example a reactive ion etching unit, a chemical etching unit or an optical etching unit.

8. Plant (1) according to one of claims 4 to 7, **characterized in that** the layer of material (20; 120; 220) is made from a photosensitive material, and **in that** the localized treatment device (50; 250) of the layer of material (20; 120; 220) comprises, firstly, an exposure unit (51; 251) emitting a luminous flux (53; 253) which passes through the droplets (30) and reaches the outer surface (21; 121; 221) of the layer of material (20; 120; 220) and, secondly, a developing unit (54; 254) of the layer of material (20; 120; 220) after exposure to the luminous flux (53; 253).

9. Surface treatment plant (1), comprising:
- a system (2) for producing an optical mask (35) according to claim 3;
- a localized treatment device (50; 250) of the substrate (10), depending on the arrangement (31) of the droplets (30) forming the optical mask (35) on the outer surface (21; 121; 221) of the layer of material (20; 120; 220), through the optical mask (35) formed on the layer of material (20; 120; 220) permeable to the luminous flux.

10. Plant (1) according to one of claims 6 to 9, **characterized in that** the substrate (10) is made from a photosensitive material, and **in that** the localized treatment device (50; 250) of the substrate (10) comprises, firstly, an exposure unit (51; 251) emitting a luminous flux (53; 253) which passes through the droplets (30) and reaches the surface (11) of the substrate (10) and, secondly, a developing unit (54; 254) of the substrate (10) after exposure to the luminous flux (53; 253).

11. Method for producing an optical mask (35) for surface treatment, in particular for surface microtexturing, the method comprising the following steps:
- a step of providing a layer of material (20; 120; 220) having an outer surface (21; 121; 221) that is exposed to the outside environment;
- a step of pretreating the layer of material (20; 120; 220), the pretreatment defining preferential fixing sites (63) of the droplets (30) to the outer surface (21; 121; 221) of the layer of material (20; 120; 220), thus enabling the arrangement (31) of the droplets (30) forming the optical mask (35) on the outer surface (21; 121; 221); and
- a step of generating and depositing droplets (30) on the outer surface (21; 121; 221) of the layer of material (20; 120; 220), in a specific arrangement (31), thus forming the optical mask (35) on the outer surface (21; 121; 221) of the layer of material (20; 120; 220).

12. Surface treatment method, comprising the following successive steps:
a) a step of providing a layer of material (20; 120; 220) having an outer surface (21; 121; 221) that is exposed to the outside environment;
b) a step of pretreating the layer of material (20; 120; 220), the pretreatment defining preferential fixing sites (63) of the droplets (30) to the outer surface (21; 121; 221) of the layer of material (20; 120; 220), thus enabling the arrangement (31) of the droplets (30) forming an optical mask (35) on the outer surface (21; 121; 221);
c) a step of generating and depositing droplets (30) on the outer surface (21; 121; 221) of the layer of material (20; 120; 220), in a specific arrangement (31), thus forming the optical mask (35) on the outer surface (21; 121; 221) of the layer of material (20; 120; 220); and
d) a step of localized treatment of the layer of material (20; 120; 220) depending on the arrangement (31) of the droplets (30) on the outer surface (21; 121; 221), through the optical mask (35) formed on the layer of material (20; 120; 220).

13. Surface treatment method, comprising the following successive steps:
a) a step of providing a substrate (10) having a surface (11) covered by a layer of material (20), having an outer surface (21) that is exposed to the outside environment;
b) a step of pretreating the layer of material (20), the pretreatment defining preferential fixing sites (63) of the droplets (30) to the outer surface (21) of the layer of material (20), thus enabling to control the arrangement (31) of the droplets (30) forming an optical mask (35) on the outer surface (21);
c) a step of generating and depositing droplets (30) on the outer surface (21) of the layer of material (20), in a specific arrangement (31), thus forming the optical mask (35) on the outer surface (21) of the layer of material (20);
d) a step of localized removal of the layer of material (20) depending on the arrangement (31) of the droplets (30) on the outer surface (21), through the optical mask (35) formed on the layer of material (20), which thus has removal areas (23) and material areas (24) forming a second mask (25) on the substrate (10); and
e) a step of localized treatment of the surface (11) of the substrate (10) through the second mask (25) formed by the layer of material (20) on the substrate (10).

14. Surface treatment method comprising the following successive steps:
a) a step of providing a layer of material (20; 120; 220) permeable to luminous radiation and having an outer surface (21; 121; 221) that is exposed to the outside environment;
b) a step of pretreating the layer of material (20; 120; 220), the pretreatment defining preferential fixing sites (63) of the droplets (30) to the outer surface (21; 121; 221) of the layer of material (20; 120; 220), thus enabling to control the arrangement (31) of the droplets (30) forming an optical mask (35) on the outer surface (21; 121; 221) ;
c) a step of providing a substrate (10) having a surface (11) arranged opposite the layer of material (20);
d) a step of generating and depositing droplets (30) on the outer surface (21) of the layer of material (20), in a specific arrangement (31), thus forming the optical mask (35) on the outer surface (21) of the layer of material (20);
e) a step of localized treatment of the surface (11) of the substrate (10) through the optical mask (35) formed by the droplets (30) on the layer of material (20).

15. Method according to claim 14, **characterized in that** during the treatment step e), a relative displacement may be carried out between the surface (11) of the substrate (10) and the layer of material (20; 120; 220) supporting the droplets (30) forming the optical mask (35), so as to regularly reproduce on the surface (11) of the substrate (10) a pattern defined by the optical mask (35).

16. Method according to one of claims 12 to 15, **characterized in that** the step of generating and depositing droplets (30) is repeated several times to modify the arrangement (31) of the droplets (30) forming the optical mask (35), before carrying out the next step.
